# EUROPEAN PATENT APPLICATION

(11) **EP 4 486 098 A1**
(43) Date of publication of application: **01.01.2025**
(21) Application number: 23904043.9
(22) Date of filing: 15.12.2023
(51) Int. Cl.: H10K 85/60, H10K 50/11

(54) **ORGANIC LIGHT EMITTING DEVICE**

(30) Priority: 16.12.2022 KR 20220177475; 13.12.2023 KR 20230181045
(71) Applicant: LG Chem, Ltd., Yeongdeungpo-gu Seoul 07336 (KR)
(72) Inventor: KIM, Hoon Jun, Daejeon 34122 (KR); JUNG, Min Woo, Daejeon 34122 (KR); HAN, Miyeon, Daejeon 34122 (KR); LEE, Jungha, Daejeon 34122 (KR); OH, Joongsuk, Daejeon 34122 (KR); CHO, Hye Min, Daejeon 34122 (KR); LEE, Hojung, Daejeon 34122 (KR); HEO, Jeonghoe, Daejeon 34122 (KR)
(74) Representative: Hoffmann Eitle
(86) International application number: PCT/KR2023/020723
(87) International publication number: WO 2024/128844

(57) **Abstract**

The present disclosure provides an organic light emitting device having improved driving voltage, efficiency and lifetime.

## Description

### [TECHNICAL FIELD]

### CROSS-REFERENCE TO RELATED APPLICATION(S)

This application claims the benefit of Korean Patent Application No. 10-2022-0177475 filed on December 16, 2022 and Korean Patent Application No. 10-2023-0181045 filed on December 13, 2023 in the Korean Intellectual Property Office, the disclosures of which are incorporated herein by reference in their entirety.

The present disclosure relates to an organic light emitting device having improved driving voltage, efficiency and lifetime.

### [BACKGROUND ART]

In general, an organic light emitting phenomenon refers to a phenomenon where electric energy is converted into light energy by using an organic material. The organic light emitting device using the organic light emitting phenomenon has characteristics such as a wide viewing angle, an excellent contrast, a fast response time, an excellent luminance, driving voltage and response speed, and thus many studies have proceeded.

The organic light emitting device generally has a structure which comprises an anode, a cathode, and an organic material layer interposed between the anode and the cathode. The organic material layer frequently has a multilayered structure that comprises different materials in order to enhance efficiency and stability of the organic light emitting device, and for example, the organic material layer may be formed of a hole injection layer, a hole transport layer, a light emitting layer, an electron transport layer, an electron injection layer and the like. In the structure of the organic light emitting device, if a voltage is applied between two electrodes, the holes are injected from an anode into the organic material layer and the electrons are injected from the cathode into the organic material layer, and when the injected holes and electrons meet each other, an exciton is formed, and light is emitted when the exciton falls to a ground state again.

Therefore, there is a continuing need to develop a new material used in organic light emitting devices as described above.

### [Prior Art Literature]

### [Patent Literature]

(Patent Literature 1) Korean Unexamined Patent Publication No. 10-2000-0051826

### [DETAILED DESCRIPTION OF THE INVENTION]

### [Technical Problem]

It is an object of the present disclosure to provide an organic light emitting device having improved driving voltage, efficiency and lifetime.

### [Technical Solution]

The present disclosure provides the following organic light emitting device:
An organic light emitting device comprising:
an anode; a light emitting layer; and a cathode,
wherein the light emitting layer includes a compound represented by the following Chemical Formula 1, and a compound represented by the following Chemical Formula 2. 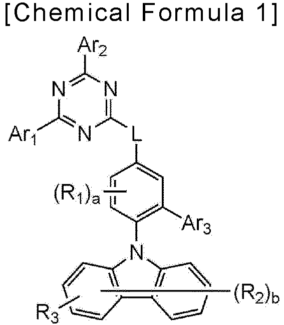
wherein, in Chemical Formula 1,
Ar₁ and Ar₂ are each independently a substituted or unsubstituted C₆₋₆₀ aryl; or a substituted or unsubstituted C₂₋₆₀ heteroaryl containing any one or more heteroatoms selected from the group consisting of N, O and S,
Ar₃ is a substituted or unsubstituted C₆₋₆₀ aryl,
L is a single bond; a substituted or unsubstituted C₆₋₆₀ arylene; or a substituted or unsubstituted C₂₋₆₀ heteroarylene containing any one or more heteroatoms selected from the group consisting of N, O, and S,
R₁ and R₂ are each independently hydrogen or deuterium,
R₃ is hydrogen, deuterium, or a substituted or unsubstituted C₆₋₆₀ aryl,
at least one of R₂ and R₃ is deuterium,
a is an integer from 0 to 3, and
b is an integer of 7, 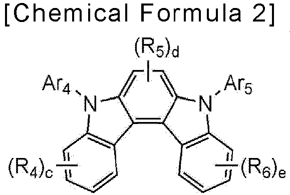
wherein, in Chemical Formula 2,
Ar₄ and Ar₅ are each independently a substituted or unsubstituted C₆₋₆₀ aryl; or a substituted or unsubstituted C₂₋₆₀ heteroaryl containing any one or more heteroatoms selected from the group consisting of N, O and S,
R₄ to R₆ are each independently hydrogen, or deuterium,
c and e are integers from 0 to 4, and
d is an integer from 0 to 2.

### [Advantageous Effects]

The organic light emitting device described above includes the compound represented by Chemical Formula 1 and the compound represented by Chemical Formula 2 and thus, can improve the efficiency, achieve low driving voltage and/or improve lifetime characteristics in the organic light emitting device.

### [BRIEF DESCRIPTION OF THE DRAWINGS]

FIG. 1 shows an example of an organic light emitting device comprising a substrate 1, an anode 2, a light emitting layer 3, and a cathode 4.
FIG. 2 shows an example of an organic light emitting device comprising a substrate 1, an anode 2, a hole injection layer 5, a first hole transport layer 6, a second hole transport layer 7, an electron blocking layer 8, a light emitting layer 3, a hole blocking layer 9, an electron injection and transport layer 10, and a cathode 4.

### [DETAILED DESCRIPTION OF THE EMBODIMENTS]

Hereinafter, embodiments of the present disclosure will be described in more detail to facilitate understanding of the invention.

As used herein, the notation 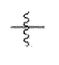 or 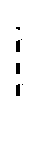 means a bond linked to another substituent group.

As used herein, the term "substituted or unsubstituted" means being unsubstituted or substituted with one or more substituent groups selected from the group consisting of deuterium; a halogen group; a nitrile group; a nitro group; a hydroxy group; a carbonyl group; an ester group; an imide group; an amino group; a phosphine oxide group; an alkoxy group; an aryloxy group; an alkylthioxy group; an arylthioxy group; an alkylsulfoxy group; an arylsulfoxy group; a silyl group; a boron group; an alkyl group; a cycloalkyl group; an alkenyl group; an aryl group; an aralkyl group; an aralkenyl group; an alkylaryl group; an alkylamine group; an aralkylamine group; a heteroarylamine group; an arylamine group; an arylphosphine group; and a heterocyclic group containing at least one of N, O and S atoms, or being unsubstituted or substituted with a substituent group to which two or more substituent groups of the above-exemplified substituent groups are linked. For example, "a substituent group in which two or more substituents are linked" may be a biphenyl group. Namely, a biphenyl group may be an aryl group, or it may be interpreted as a substituent group in which two phenyl groups are linked. In one example, the term "substituted or unsubstituted" may be understood as meaning "being unsubstituted or substituted with one or more substituents, for example, 1 to 5 substituents, selected from the group consisting of deuterium, halogen, a C₁₋₁₀ alkyl, a C₁₋₁₀ alkoxy, a C₆₋₂₀ aryl and a heteroaryl containing one or more heteroatoms of N, O and S". Further, the term "substituted with one or more substituents" as used herein may be understood as meaning "being substituted with 1 to 5 substituents", or "being substituted with one or two substituents".

In the present disclosure, the carbon number of a carbonyl group is not particularly limited, but is preferably 1 to 40. Specifically, the carbonyl group may be a substituent group having the following structural formulas, but is not limited thereto.

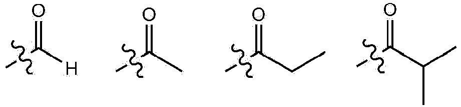

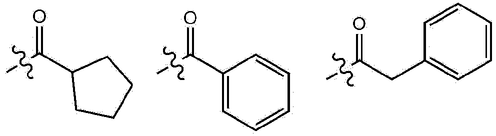

In the present disclosure, an ester group may have a structure in which oxygen of the ester group may be substituted by a straight-chain, branched-chain, or cyclic alkyl group having 1 to 25 carbon atoms, or an aryl group having 6 to 25 carbon atoms. Specifically, the ester group may be a substituent group having the following structural formulas, but is not limited thereto.

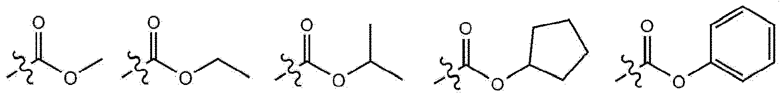

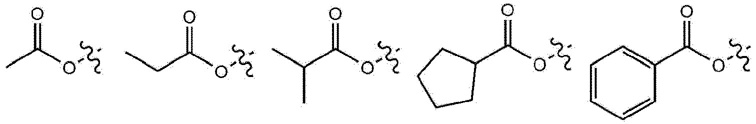

In the present disclosure, the carbon number of an imide group is not particularly limited, but is preferably 1 to 25. Specifically, the imide group may be a substituent group having the following structural formulas, but is not limited thereto.

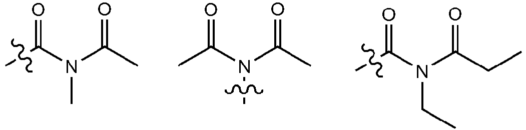

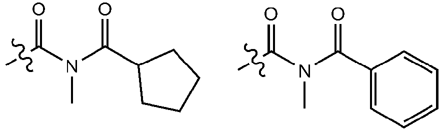

In the present disclosure, a silyl group specifically includes a trimethylsilyl group, a triethylsilyl group, a t-butyldimethylsilyl group, a vinyldimethylsilyl group, a propyldimethylsilyl group, a triphenylsilyl group, a diphenylsilyl group, a phenylsilyl group and the like, but is not limited thereto.

In the present disclosure, a boron group specifically includes a trimethylboron group, a triethylboron group, a t-butyldimethylboron group, a triphenylboron group, and a phenylboron group, but is not limited thereto.

In the present disclosure, examples of a halogen group include fluorine, chlorine, bromine, or iodine.

In the present disclosure, the alkyl group may be straight-chain or branched-chain, and the carbon number thereof is not particularly limited, but is preferably 1 to 40. According to one embodiment, the carbon number of the alkyl group is 1 to 20. According to another embodiment, the carbon number of the alkyl group is 1 to 10. According to another embodiment, the carbon number of the alkyl group is 1 to 6. Specific examples of the alkyl group include methyl, ethyl, propyl, n-propyl, isopropyl, butyl, n-butyl, isobutyl, tert-butyl, sec-butyl, 1-methyl-butyl, 1-ethyl-butyl, pentyl, n-pentyl, isopentyl, neopentyl, tert-pentyl, hexyl, n-hexyl, 1-methylpentyl, 2-methylpentyl, 4-methyl-2-pentyl, 3,3-dimethylbutyl, 2-ethylbutyl, heptyl, n-heptyl, 1-methylhexyl, cyclopentylmethyl, cyclohexylmethyl, octyl, n-octyl, tert-octyl, 1-methylheptyl, 2-ethylhexyl, 2-propylpentyl, n-nonyl, 2,2-dimethylheptyl, 1-ethyl-propyl, 1,1-dimethyl-propyl, isohexyl, 2-methylpentyl, 4-methylhexyl, 5-methylhexyl, and the like, but are not limited thereto.

In the present disclosure, the alkenyl group may be straight-chain or branched-chain, and the carbon number thereof is not particularly limited, but is preferably 2 to 40. According to one embodiment, the carbon number of the alkenyl group is 2 to 20. According to another embodiment, the carbon number of the alkenyl group is 2 to 10. According to still another embodiment, the carbon number of the alkenyl group is 2 to 6. Specific examples thereof include vinyl, 1-propenyl, isopropenyl, 1-butenyl, 2-butenyl, 3-butenyl, 1-pentenyl, 2-pentenyl, 3-pentenyl, 3-methyl-1-butenyl, 1,3-butadienyl, allyl, 1-phenylvinyl-1-yl, 2-phenylvinyl-1-yl, 2,2-diphenylvinyl-1-yl, 2-phenyl-2-(naphthyl-1-yl)vinyl-1-yl, 2,2-bis(diphenyl-1-yl)vinyl-1-yl, a stilbenyl group, a styrenyl group, and the like, but are not limited thereto.

In the present disclosure, a cycloalkyl group is not particularly limited, but the carbon number thereof is preferably 3 to 60. According to one embodiment, the carbon number of the cycloalkyl group is 3 to 30. According to another embodiment, the carbon number of the cycloalkyl group is 3 to 20. According to still another embodiment, the carbon number of the cycloalkyl group is 3 to 6. Specific examples thereof include cyclopropyl, cyclobutyl, cyclopentyl, 3-methylcyclopentyl, 2,3-dimethylcyclopentyl, cyclohexyl, 3-methylcyclohexyl, 4-methylcyclohexyl, 2,3-dimethylcyclohexyl, 3,4,5-trimethylcyclohexyl, 4-tert-butylcyclohexyl, cycloheptyl, cyclooctyl, and the like, but are not limited thereto.

In the present disclosure, an aryl group is not particularly limited, but the carbon number thereof is preferably 6 to 60, and it may be a monocyclic aryl group or a polycyclic aryl group. According to one embodiment, the carbon number of the aryl group is 6 to 30. According to one embodiment, the carbon number of the aryl group is 6 to 20. The aryl group may be a phenyl group, a biphenyl group, a terphenyl group or the like as the monocyclic aryl group, but is not limited thereto. The polycyclic aryl group includes a naphthyl group, an anthracenyl group, a phenanthrenyl group, a pyrenyl group, a perylenyl group, a chrysenyl group, or the like, but is not limited thereto.

In the present disclosure, the fluorenyl group may be substituted, and two substituent groups may be linked with each other to form a spiro structure. In the case where the fluorenyl group is substituted, 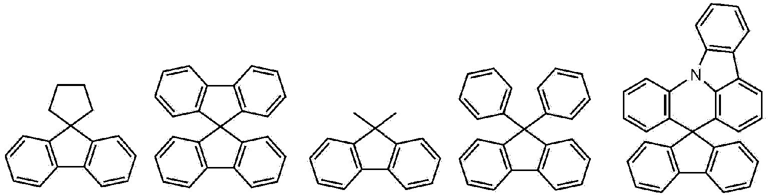 and the like can be formed. However, the structure is not limited thereto.

In the present disclosure, a heterocyclic group is a heterocyclic group containing one or more of O, N, Si and S as a heteroatom, and the carbon number thereof is not particularly limited, but is preferably 2 to 60. Examples of the heterocyclic group include a thiophene group, a furan group, a pyrrole group, an imidazole group, a thiazole group, an oxazol group, an oxadiazol group, a triazol group, a pyridyl group, a bipyridyl group, a pyrimidyl group, a triazine group, an acridyl group, a pyridazine group, a pyrazinyl group, a quinolinyl group, a quinazoline group, a quinoxalinyl group, a phthalazinyl group, a pyridopyrim idinyl group, a pyridopyrazinyl group, a pyrazinopyrazinyl group, an isoquinoline group, an indole group, a carbazole group, a benzoxazole group, a benzoimidazole group, a benzothiazol group, a benzocarbazole group, a benzothiophene group, a dibenzothiophene group, a benzofuranyl group, a phenanthroline group, an isoxazolyl group, a thiadiazolyl group, a phenothiazinyl group, a dibenzofuranyl group, and the like, but are not limited thereto.

In the present disclosure, the aryl group in the aralkyl group, the aralkenyl group, the alkylaryl group and the arylamine group is the same as the aforementioned examples of the aryl group. In the present disclosure, the alkyl group in the aralkyl group, the alkylaryl group and the alkylamine group is the same as the aforementioned examples of the alkyl group. In the present disclosure, the heteroaryl in the heteroarylamine can be applied to the aforementioned description of the heterocyclic group. In the present disclosure, the alkenyl group in the aralkenyl group is the same as the aforementioned examples of the alkenyl group. In the present disclosure, the aforementioned description of the aryl group may be applied except that the arylene is a divalent group. In the present disclosure, the aforementioned description of the heterocyclic group can be applied except that the heteroarylene is a divalent group. In the present disclosure, the aforementioned description of the aryl group or cycloalkyl group can be applied except that the hydrocarbon ring is not a monovalent group but formed by combining two substituent groups. In the present disclosure, the aforementioned description of the heterocyclic group can be applied, except that the heterocycle is not a monovalent group but formed by combining two substituent groups.

Hereinafter, the present disclosure will be described in detail for each configuration.

### Anode and Cathode

An anode and a cathode used in the present disclosure mean electrodes used in an organic light emitting device.

As the anode material, generally, a material having a large work function is preferably used so that holes can be smoothly injected into the organic material layer. Specific examples of the anode material include metals such as vanadium, chrome, copper, zinc, and gold, or an alloy thereof; metal oxides such as zinc oxides, indium oxides, indium tin oxides (ITO), and indium zinc oxides (IZO); a combination of metals and oxides, such as ZnO:Al or SnO₂:Sb; conductive polymers such as poly(3-methylthiophene), poly[3,4-(ethylene-1,2-dioxy)thiophene](PEDOT), polypyrrole, and polyaniline, and the like, but are not limited thereto.

As the cathode material, generally, a material having a small work function is preferably used so that electrons can be easily injected into the organic material layer. Specific examples of the cathode material include metals such as magnesium, calcium, sodium, potassium, titanium, indium, yttrium, lithium, gadolinium, aluminum, silver, tin, and lead, or an alloy thereof; a multilayered structure material such as LiF/Al or LiO₂/Al, and the like, but are not limited thereto.

### Hole injection layer

The organic light emitting device according to the present disclosure may further include a hole injection layer on the anode, if necessary.

The hole injection layer is a layer injecting holes from an electrode, and the hole injection material is preferably a compound which has a capability of transporting the holes, has a hole injection effect in the anode and an excellent hole injection effect to the light emitting layer or the light emitting material, prevents movement of an exciton generated in the light emitting layer to the electron injection layer or the electron injection material, and is excellent in the ability to form a thin film. Further, it is preferable that a HOMO (highest occupied molecular orbital) of the hole injection material is between the work function of the anode material and a HOMO of a peripheral organic material layer.

Specific examples of the hole injection material include metal porphyrin, oligothiophene, an arylamine-based organic material, a hexanitrilehexaazatriphenylene-based organic material, a quinacridone-based organic material, a perylene-based organic material, anthraquinone, polyaniline and polythiophene-based conductive polymer, and the like, but are not limited thereto.

### Hole Transport Layer

The organic light emitting device according to the present disclosure may include a hole transport layer on the anode (or on the hole injection layer if the hole injection layer exists), if necessary.

The hole transport layer is a layer that receives holes from an anode or a hole injection layer transports the holes to the light emitting layer. The hole transport material is suitably a material having large mobility to the holes, which can receive injection of holes from the anode or the hole injection layer and transfer the holes to the light emitting layer.

Specific examples of the hole transport material include an arylamine-based organic material, a conductive polymer, a block copolymer in which a conjugate portion and a non-conjugate portion are present together, and the like, but are not limited thereto.

On the other hand, the hole transport layer may be composed of two or more materials, and respective materials may be mixed to form one layer, or may be composed of a separate layer. When constituting a separate layer, it can be distinguished by expressions such as 'first' and 'second', which can be understood to be merely for the purpose of distinction

### Electron Blocking Layer

The organic light emitting device according to the present disclosure may include an electron blocking layer on the hole transport layer, if necessary.

The electron blocking layer means a layer provided between the hole transport layer and the light emitting layer in order to prevent the electrons injected in the anode from being transferred to the hole transport layer without being recombined in the light emitting layer, which may also be referred to as an electron stopping layer or an electron inhibition layer. The electron blocking layer is preferably a material having the smaller electron affinity than the electron transport layer.

### Light Emitting Layer

The light emitting layer used in the present disclosure is a layer that can emit light in the visible light region by combining holes and electrons transported from the anode and the cathode. Generally, the light emitting layer includes a host material and a dopant material, and in the present disclosure, the compound represented by Chemical Formula 1 and the compound represented by Chemical Formula 2 are included as a host.

Preferably, Ar₁ and Ar₂ are each independently a substituted or unsubstituted C₆₋₂₀ aryl; or a substituted or unsubstituted C₂₋₂₀ heteroaryl containing any one or more heteroatoms selected from the group consisting of N, O and S.

More preferably, Ar₁ and Ar₂ are each independently phenyl, biphenylyl, dibenzofuranyl, dibenzothiophenyl, carbazolyl, or phenyl carbazolyl, wherein the Ar₁ and Ar₂ may each independently be unsubstituted or substituted with at least one deuterium.

Most preferably, Ar₁ and Ar₂ may each independently be any one selected from the group consisting of:

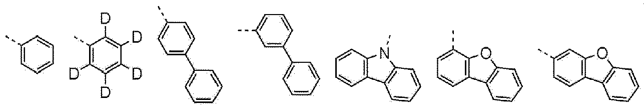

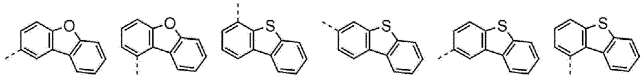

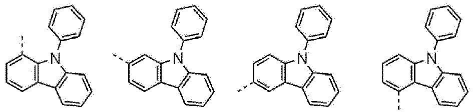

Preferably, at least one of Ar₁ and Ar₂ may be a substituted or unsubstituted C₆₋₂₀ aryl.

More preferably, at least one of Ar₁ and Ar₂ may be phenyl or phenyl substituted with 5 deuteriums.

Preferably, both Ar₁ and Ar₂ may be a substituted or unsubstituted C₆₋₂₀ aryl.

Preferably, Ar₁ and Ar₂ may be each independently phenyl or biphenylyl.

Preferably, Ar₃ may be a substituted or unsubstituted C₆₋₂₀ aryl.

More preferably, Ar₃ may be phenyl or biphenylyl, wherein the Ar₃ may be unsubstituted or substituted with at least one deuterium.

Most preferably, Ar₃ may be any one selected from the group consisting of:

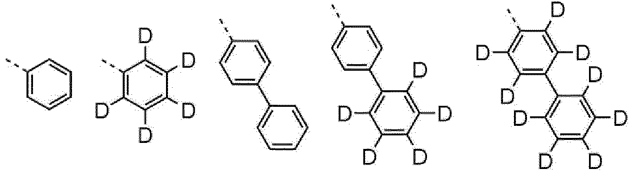

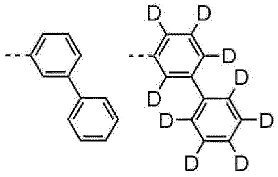

Preferably, L may be a single bond.

Preferably, R₃ may be hydrogen, deuterium, or a substituted or unsubstituted C₆₋₂₀ aryl.

More preferably, R₃ may be hydrogen, deuterium, phenyl, or phenyl substituted with five deuteriums.

Most preferably, R₃ may be phenyl substituted with five deuteriums.

Preferably, at least one of R₂ and R₃ is deuterium, and the others may be hydrogen, deuterium, phenyl, or phenyl substituted with 1 to 5 deuteriums.

Preferably, the Chemical Formula 1 may be represented by any one of the following Chemical Formulas 1-1 to 1-4: 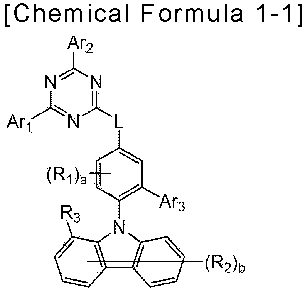 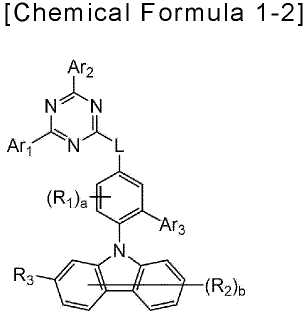 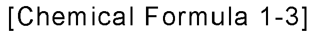 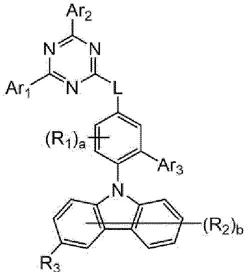 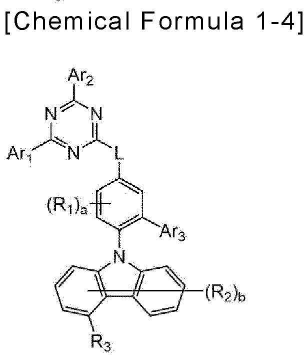
wherein, in Chemical Formulas 1-1 to 1-4,
Ar₁ to Ars, L, R₁ and R₂ are as defined in Chemical Formula 1, and
R₃ may be phenyl unsubstituted or substituted with 1 to 5 deuteriums.

Representative examples of the compound represented by Chemical Formula 1 are as follows:

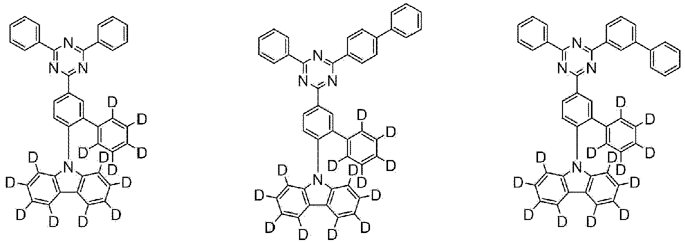

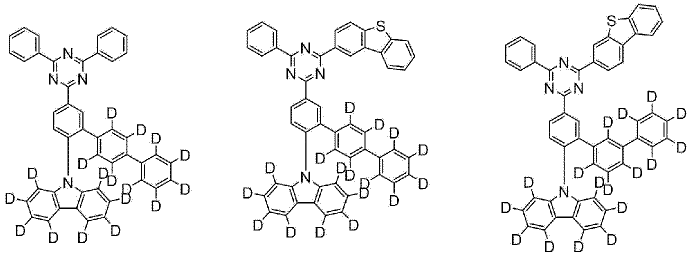

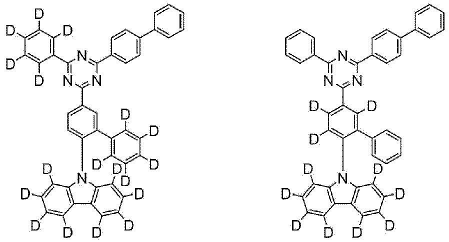

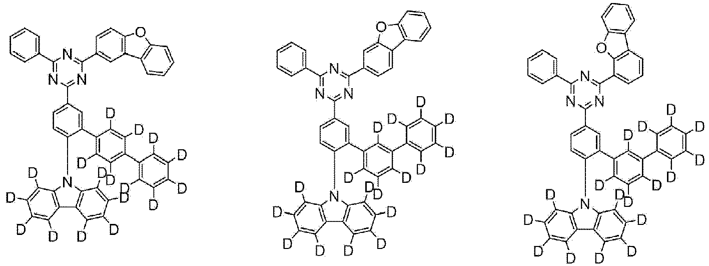

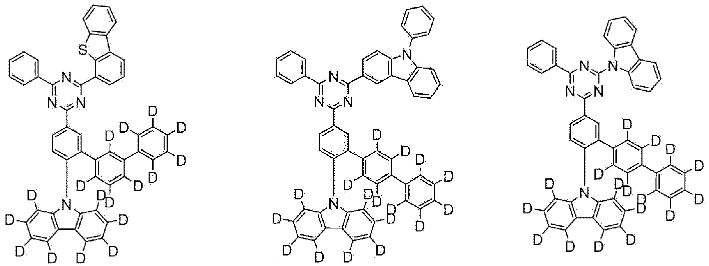

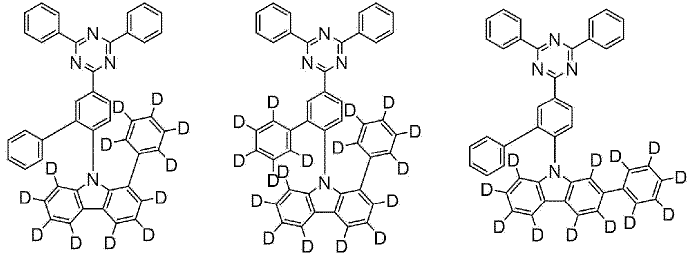

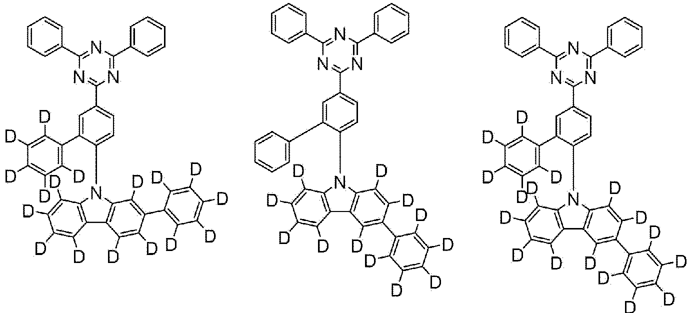

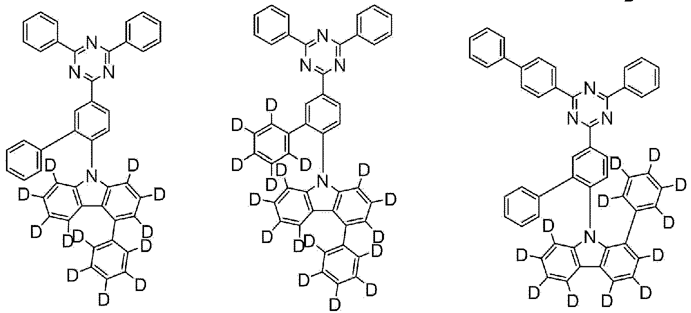

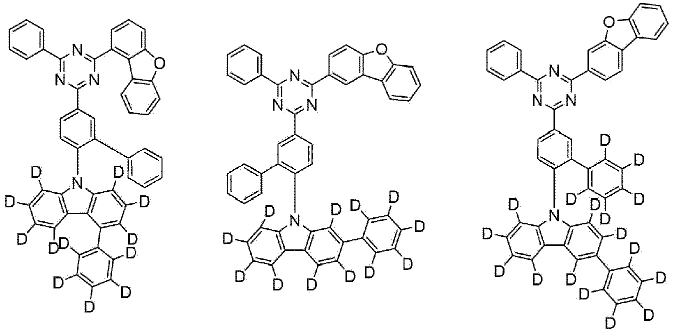

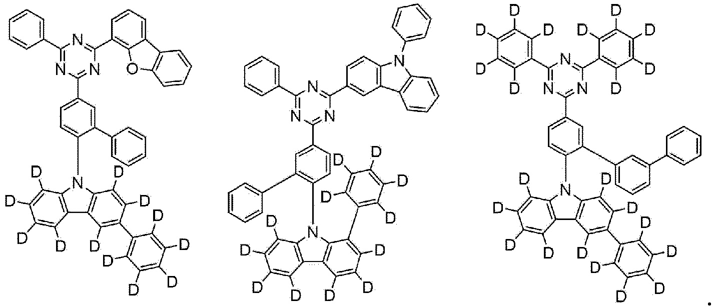

The compound represented by Chemical Formula 1 can be prepared, for example, by a preparation method as shown in the following Reaction Scheme 1, and the other remaining compounds can also be prepared in a similar manner. 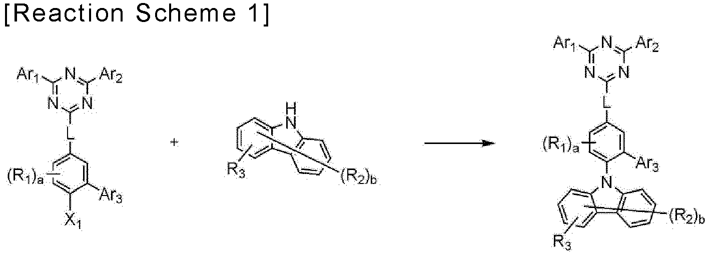 wherein, in Reaction Scheme 1, Ar₁ to Ar₃, L, R₁ to R₃, a and b are the same as defined in Chemical Formula 1, and X₁ is halogen, preferably X₁ is fluoro, chloro or bromo.

Reaction Scheme 1 is an amine substitution reaction, which is preferably carried out in the presence of a palladium catalyst and a base, and a reactive group for the amine substitution reaction can be changed as known in the art. The preparation method can be further embodied in Preparation Examples described hereinafter.

Preferably, Ar₄ and Ar₅ are each independently a substituted or unsubstituted C₆₋₂₀ aryl; or a substituted or unsubstituted C₂₋₂₀ heteroaryl containing any one or more heteroatoms selected from the group consisting of N, O, and S.

More preferably, Ar₄ and Ar₅ may be each independently biphenylyl, terphenylyl, dibenzofuranyl, dibenzofuranyl phenyl, dibenzothiophenyl, or phenyl carbazolyl, wherein the Ar₄ and Ar₅ may be unsubstituted or substituted with at least one deuterium.

More preferably, Ar₄ and Ar₅ may each independently be any one selected from the group consisting of:

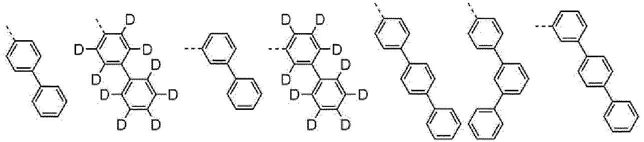

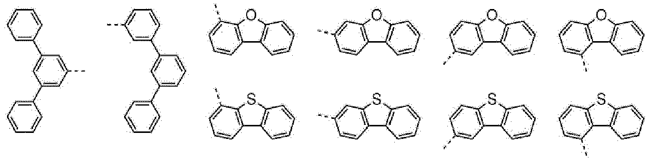

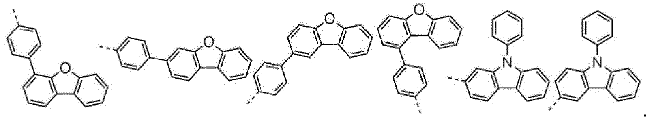

More preferably, Ar₄ and Ar₅ may each be biphenylyl substituted with 9 deuteriums.

Preferably, at least one of Ar₄ and Ar₅ may be a substituted or unsubstituted C₆₋₆₀ aryl.

More preferably, at least one of Ar₄ and Ar₅ may be a substituted or unsubstituted C₆₋₂₀ aryl.

More preferably, at least one of Ar₄ and Ar₅ may be any one selected from the group consisting of:

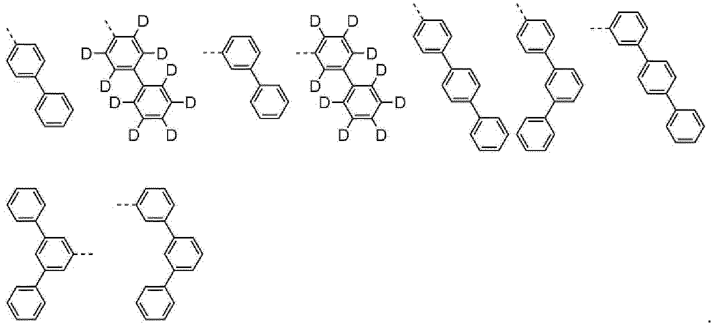

Preferably, R₄ to R₆ are deuterium, and c+d+e may be an integer from 6 to 10.

More preferably, R₄ to R₆ are deuterium, and c+d+e may be an integer from 8 to 10.

Representative examples of the compound represented by Chemical Formula 2 are as follows:

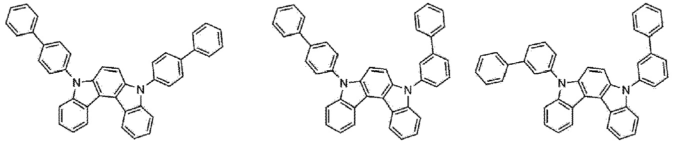

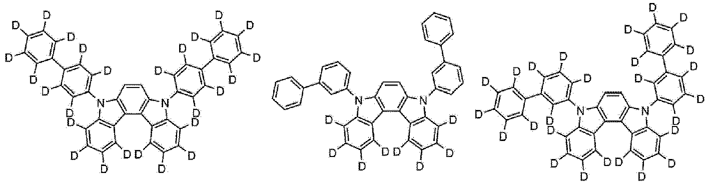

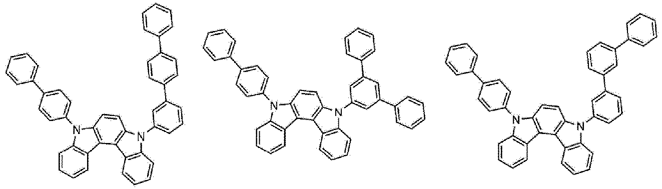

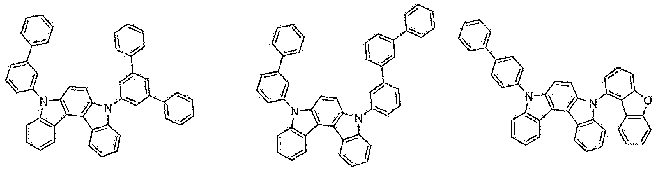

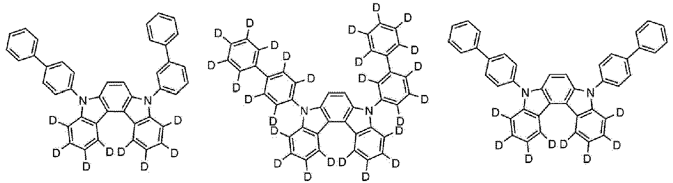

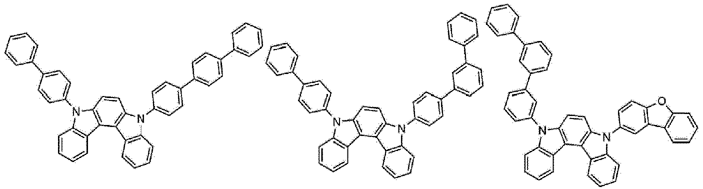

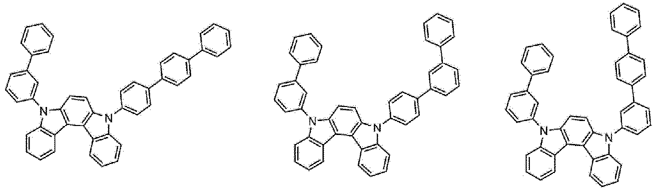

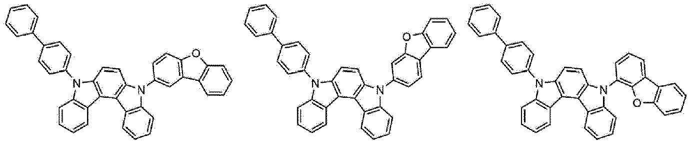

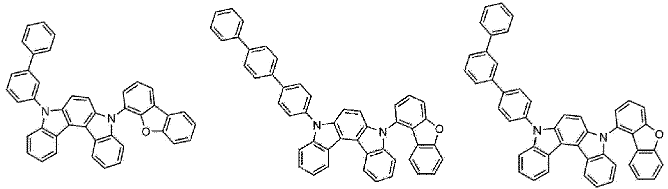

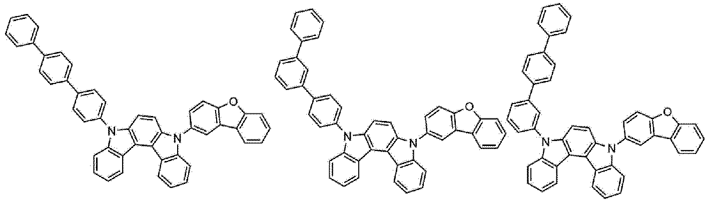

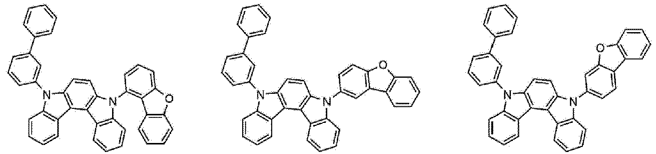

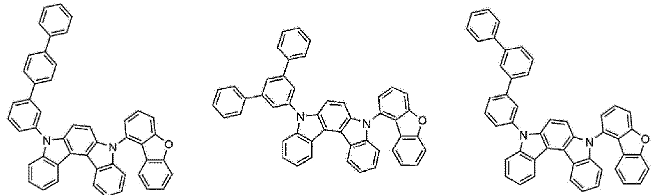

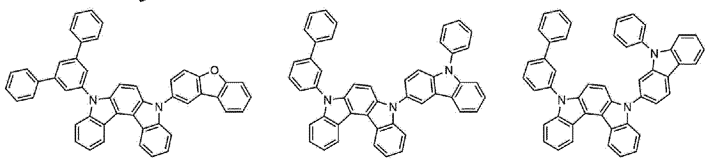

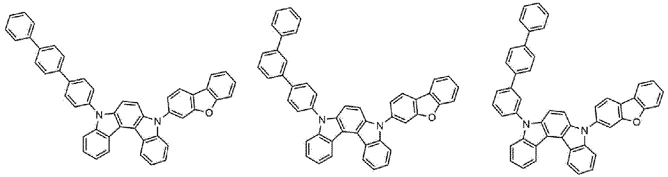

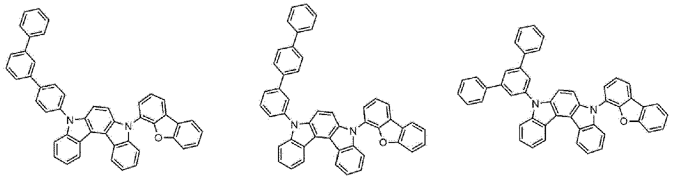

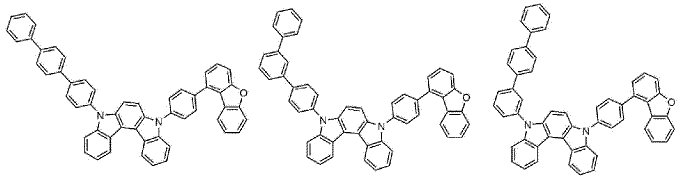

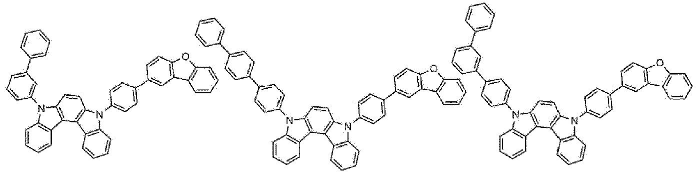

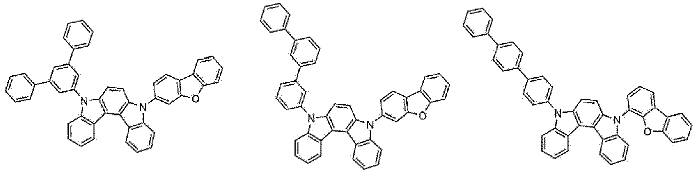

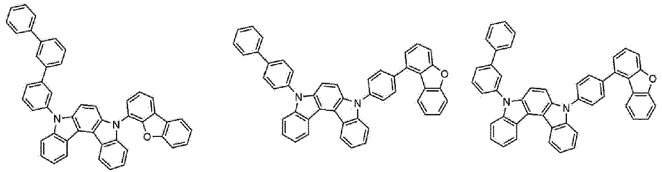

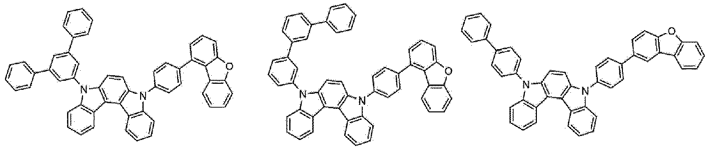

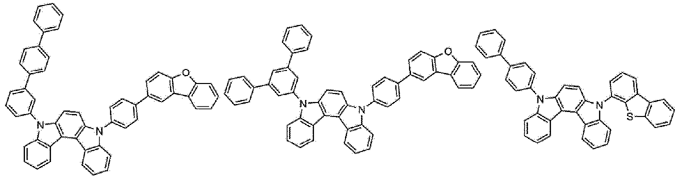

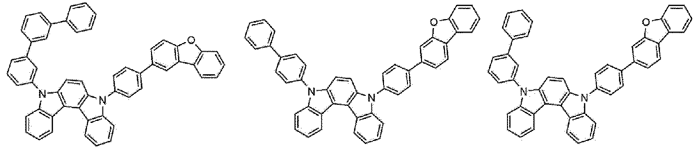

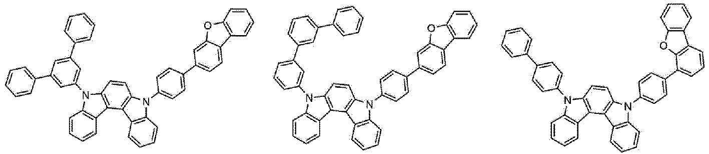

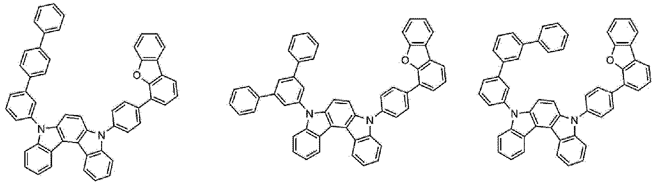

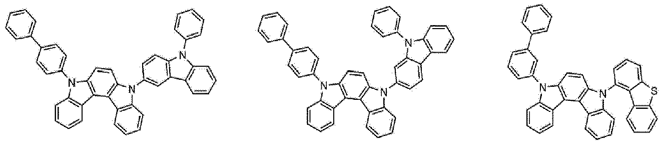

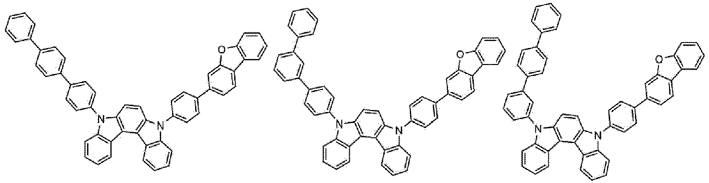

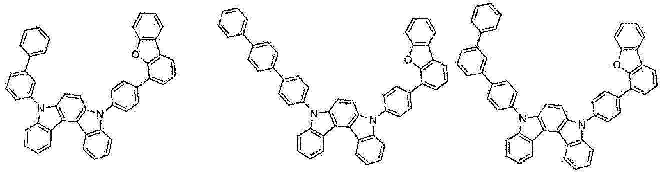

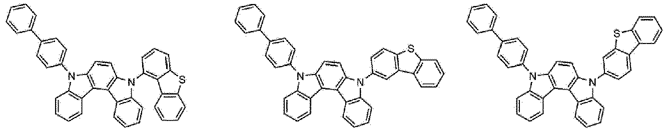

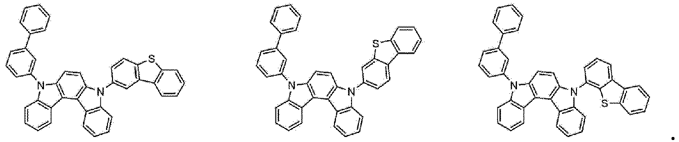

The compound represented by Chemical Formula 2 can be prepared, for example, by a preparation method as shown in the following Reaction Scheme 2, and the other remaining compounds can also be prepared in a similar manner. 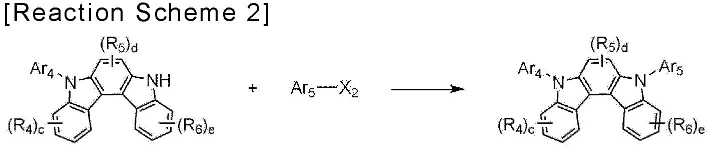 wherein, in Reaction Scheme 2, Ar₄ to Ar₅ are the same as defined in Chemical Formula 2, and X₂ is halogen, preferably X₂ is fluoro, chloro or bromo.

Reaction Scheme 2 is an amine substitution reaction, which is preferably carried out in the presence of a palladium catalyst and a base, and a reactive group for the amine substitution reaction can be changed as known in the art. The preparation method can be further embodied in Preparation Examples described hereinafter.

Preferably, the weight ratio of the compound represented by Chemical Formula 1 and the compound represented by Chemical Formula 2 in the light emitting layer is 10:90 to 90:10, more preferably 20:80 to 80:20, 30:70 to 70:30, or 40:60 to 60:40.

On the other hand, the light emitting layer may further include a dopant in addition to the host. The dopant material is not particularly limited as long as it is a material used for the organic light emitting device. As an example, an aromatic amine derivative, a styrylamine compound, a boron complex, a fluoranthene compound, a metal complex, and the like can be mentioned. Specific examples of the aromatic amine derivatives include substituted or unsubstituted fused aromatic ring derivatives having an arylamino group, examples thereof include pyrene, anthracene, chrysene, and periflanthene having an arylamino group, and the like. The styrylamine compound is a compound where at least one arylvinyl group is substituted in substituted or unsubstituted arylamine, in which one or two or more substituent groups selected from the group consisting of an aryl group, a silyl group, an alkyl group, a cycloalkyl group, and an arylamino group are substituted or unsubstituted. Specific examples thereof include styrylamine, styryldiamine, styryltriamine, styryltetramine, and the like, but are not limited thereto. Further, examples of the metal complex include an iridium complex, a platinum complex, and the like, but are not limited thereto.

### Hole Blocking Layer

The organic light emitting device according to the present disclosure may include an electron transport layer on the light emitting layer, if necessary.

The hole blocking layer is a layer provided between the electron transport layer and the light emitting layer in order to prevent the holes injected in the anode from being transferred to the electron transport layer without being recombined in the light emitting layer, which may also be referred to as a hole inhibition layer or a hole stopping layer. The hole blocking layer is preferably a material having the large ionization energy.

### Electron Transport Layer

The organic light emitting device according to the present disclosure may include an electron transport layer on the light emitting layer, if necessary.

The electron transport layer is a layer that receives the electrons from the cathode or the electron injection layer formed on the cathode and transports the electrons to the light emitting layer, and that suppress the transfer of holes from the light emitting layer, and an electron transport material is suitably a material which may receive well injection of electrons from a cathode and transfer the electrons to a light emitting layer, and has a large mobility for electrons.

Specific examples of the electron transport material include: an Al complex of 8-hydroxyquinoline; a complex including Alqs; an organic radical compound; a hydroxyflavone-metal complex, and the like, but are not limited thereto. The electron transport layer may be used with any desired cathode material, as used according to a conventional technique. In particular, appropriate examples of the cathode material are a typical material which has a low work function, followed by an aluminum layer or a silver layer. Specific examples thereof include cesium, barium, calcium, ytterbium, and samarium, in each case followed by an aluminum layer or a silver layer.

### Electron Injection Layer

The organic light emitting device according to the present disclosure may further include an electron injection layer on the light emitting layer (or on an electron transport layer, if the electron transport layer exists), if necessary.

The electron injection layer is a layer which injects electrons from an electrode, and is preferably a compound which has a capability of transporting electrons, has an effect of injecting electrons from a cathode and an excellent effect of injecting electrons into a light emitting layer or a light emitting material, prevents excitons produced from the light emitting layer from moving to a hole injection layer, and is also excellent in the ability to form a thin film.

Specific examples of the electron injection layer include fluorenone, anthraquinodimethane, diphenoquinone, thiopyran dioxide, oxazole, oxadiazole, triazole, imidazole, perylenetetracarboxylic acid, fluorenylidene methane, anthrone, and the like, and derivatives thereof, a metal complex compound, a nitrogen-containing 5-membered ring derivative, and the like, but are not limited thereto.

Examples of the metal complex compound include 8-hydroxyquinolinato lithium, bis(8-hydroxyquinolinato)zinc, bis(8-hydroxyquinolinato)copper, bis(8-hydroxyquinolinato)manganese, tris(8-hydroxyquinolinato)aluminum, tris(2-methyl-8-hydroxyquinolinato)aluminum, tris(8-hydroxyquinolinato)gallium, bis(10-hydroxybenzo[h]quinolinato)beryllium, bis(10-hydroxybenzo[h]quinolinato)zinc, bis(2-methyl-8-quinolinato)chlorogallium, bis(2-methyl-8-quinolinato)(o-cresolato)gallium, bis(2-methyl-8-quinolinato)(1-naphtholato)aluminum, bis(2-methyl-8-quinolinato)(2-naphtholato)gallium, and the like, but are not limited thereto.

On the other hand, in the present disclosure, the "electron injection and transport layer" is a layer that performs both the roles of the electron injection layer and the electron transport layer, and the materials that perform the roles of each layer may be used alone or stacked and used in combination, without being limited thereto.

### Organic Light Emitting Device

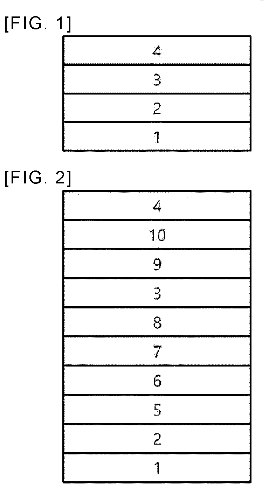

The structure of the organic light emitting device according to the present disclosure is illustrated in FIGS. 1 and 2. FIG. 1 shows an example of an organic light emitting device comprising a substrate 1, an anode 2, a light emitting layer 3, and a cathode 4. FIG. 2 shows an example of an organic light emitting device comprising a substrate 1, an anode 2, a hole injection layer 5, a first hole transport layer 6, a second hole transport layer 7, an electron blocking layer 8, a light emitting layer 3, a hole blocking layer 9, an electron injection and transport layer 10, and a cathode 4.

The organic light emitting device according to the present disclosure can be manufactured by sequentially stacking the above-described structures. In this case, the organic light emitting device may be manufactured by depositing a metal, metal oxides having conductivity, or an alloy thereof on the substrate by using a PVD (physical vapor deposition) method such as a sputtering method or an e-beam evaporation method to form the anode, forming the respective layers described above thereon, and then depositing a material that can be used as the cathode thereon. In addition to such a method, the organic light emitting device may be manufactured by sequentially depositing from the cathode material to the anode material on a substrate in the reverse order of the above-mentioned configuration (WO 2003/012890). Further, the light emitting layer may be formed by subjecting hosts and dopants to a vacuum deposition method and a solution coating method. Herein, the solution coating method means a spin coating, a dip coating, a doctor blading, an inkjet printing, a screen printing, a spray method, a roll coating, or the like, but is not limited thereto.

Meanwhile, the organic light emitting device according to the present disclosure may be a bottom emission device, a top emission device, or a double-sided light emitting device, and particularly, may be a bottom emission device that requires relatively high luminous efficiency.

Below, preferable embodiments are presented to assist in the understanding of the present disclosure. The following examples are only provided for a better understanding of the present disclosure, and is not intended to limit the content of the present disclosure.

### [Preparation Example]

### Preparation Example 1: Preparation of Compound 1-1

### (Preparation Example 1-1) Preparation of Compound 1-1a

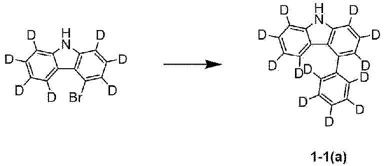

4-Bromo-9H-carbazole-1,2,3,5,6,7,8-d7(30 g, 118.5 mmol) and (phenyl-d5)boronic acid(15 g, 118.5mmol) were added to 600 ml of tetrahydrofuran under a nitrogen atmosphere, and the mixture was stirred and refluxed. Then, potassium carbonate (49.1 g, 355.5 mmol) was dissolved in 49 ml of water and added thereto, and the mixture was sufficiently stirred, and then tetrakistriphenyl-phosphinopalladium (4.1 g, 3.6 mmol) was added. After the reaction for 1 hour, the reaction mixture was cooled to room temperature, and then the resulting solid was filtered. The solid was added to and dissolved in 1513 mL of chloroform, washed twice with water, and the organic layer was separated, to which anhydrous magnesium sulfate was added, stirred, then filtered, and the filtrate was distilled under reduced pressure. The concentrated compound was recrystallized from chloroform and ethyl acetate to give a while solid compound 1-1(a) (19.4g, 64%, MS: [M+H]⁺ = 256.4).

### (Preparation Example 1-2) Preparation of Compound 1-1

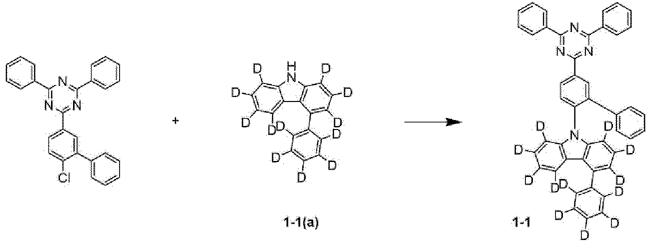

2-(6-Chloro-[1,1 '-biphenyl]-3-yl)-4,6-diphenyl-1,3,5-triazine(20g, 47.6mmol) and 1-1(a)(12.2g, 47.6mmol) were added to 200ml of xylene under a nitrogen atmosphere, and the mixture was stirred and refluxed. Then, sodium tert-butoxide (5.8 g, 60.5 mmol) was added thereto, and the mixture was sufficiently stirred, and then bis(tri-tert-butylphosphine)palladium (0.3 g, 0.6 mmol) was added. After the reaction for 1 hour, the reaction mixture was cooled to room temperature, and then the resulting solid was filtered. The solid was added to and dissolved in 380 mL of chloroform, washed twice with water, and the organic layer was separated, to which anhydrous magnesium sulfate was added, stirred, then filtered, and the filtrate was distilled under reduced pressure. The concentrated compound was recrystallized from chloroform and ethyl acetate to give a yellow solid compound 1-1 (18.3g, 60%, MS: [M+H]⁺ = 639.8).

### Preparation Example 2: Preparation of Compound 1-2

### (Preparation Example 2-1) Preparation of Compound 1-2(a)

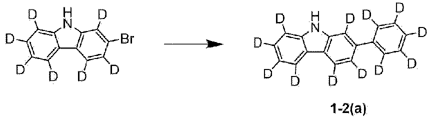

A white solid compound 1-12(b) (17.9 g, 59%, MS: [M+H]⁺ = 256.4) was prepared in the same manner as in Preparation Example 1-1, except that 2-bromo-9H-carbazole-1,2,3,5,6,7,8-d7 was used instead of 4-bromo-9H-carbazole-1,2,3,5,6,7,8-d7.

### (Preparation Example 2-2) Preparation of Compound 1-2

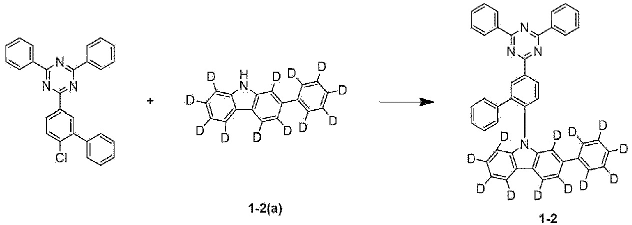

A yellow solid compound 1-2 (19.2 g, 63%, MS: [M+H]⁺ = 639.8) was prepared in the same manner as in Preparation Example 1, except that Compound 1-2(a) was used instead of Compound 1-1(a).

### Preparation Example 3: Preparation of Compound 1-3

### (Preparation Example 3-1) Preparation of Compound 1-3(a)

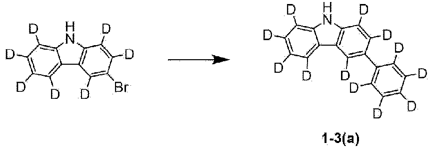

A white solid compound 1-12(b) (21.5 g, 71%, MS: [M+H]⁺ = 256.4) was prepared in the same manner as in Preparation Example 1-1, except that 3-bromo-9H-carbazole-1,2,3,5,6,7,8-d7 was used instead of 4-bromo-9H-carbazole-1,2,3,5,6,7,8-d7.

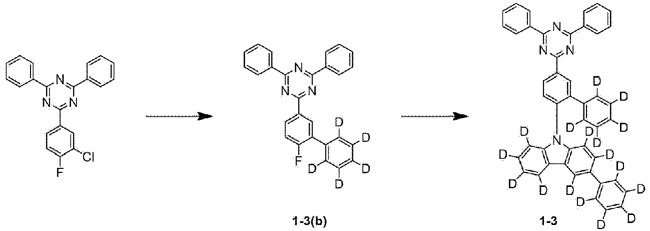

### (Preparation Example 3-2) Preparation of Compound 1-3(b)

2-(3-Chloro-4-fluorophenyl)-4,6-diphenyl-1,3,5-triazine(30 g, 82.9 mmol) and (phenyl-d5)boronic acid(10.5 g, 82.9mmol) were added to 600 ml of tetrahydrofuran under a nitrogen atmosphere, and the mixture was stirred and refluxed. Then, potassium carbonate (34.4 g, 248.8 mmol) was dissolved in 34 ml of water and added thereto, and the mixture was sufficiently stirred, and then tetrakistriphenyl-phosphinopalladium (2.9 g, 2.5 mmol) was added. After the reaction for 3 hours, the reaction mixture was cooled to room temperature, and then the resulting solid was filtered. The solid was added to 1700 mL of chloroform, dissolved, washed twice with water, and the organic layer was separated, to which anhydrous magnesium sulfate was added, stirred, then filtered, and the filtrate was distilled under reduced pressure. The concentrated compound was recrystallized from chloroform and ethyl acetate to give a while solid compound 1-3(b)(24g, 71%, MS: [M+H]⁺ = 409.5).

### (Preparation Example 3-3) Preparation of Compound 1-3

A yellow solid compound 1-3 (15.8 g, 50%, MS: [M+H]⁺ = 644.9) was prepared in the same manner as in Preparation Example 1-2, except that Compound 1-3(a) was used instead of 2-(6-chloro-[1,1'-biphenyl]-3-yl)-4,6-diphenyl-1,3,5-triazine, and Compound 1-3(a) was used instead of Compound 1-1(a).

### Preparation Example 4: Preparation of Compound 1-4

### (Preparation Example 4-1) Preparation of Compound 1-4(a)

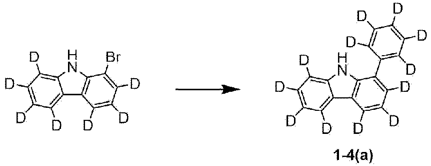

A white solid compound 1-12(b) (20.0 g, 66%, MS: [M+H]⁺ = 256.4) was prepared in the same manner as in Preparation Example 1-1, except that 1-bromo-9H-carbazole-1,2,3,5,6,7,8-d7 was used instead of 4-bromo-9H-carbazole-1,2,3,5,6,7,8-d7.

### (Preparation Example 4-2) Preparation of Compound 1-4

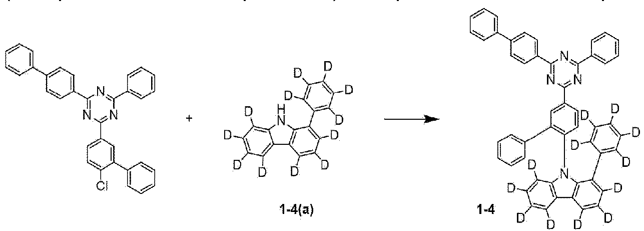

A yellow solid compound 1-4 (19.3 g, 67%, MS: [M+H]⁺ = 715.9) was prepared in the same manner as in Preparation Example 1-2, except that 2-([1,1'-biphenyl]-4-yl)-4-(6-chloro-[1,1'-biphenyl]-3-yl)-6-phenyl-1,3,5-triazine was used instead of 2-(6-chloro-[1,1'-biphenyl]-3-yl)-4,6-diphenyl-1,3,5-triazine, and Compound 1-4(a) was used instead of Compound 1-1(a).

### Preparation Example 5: Preparation of Compound 1-5

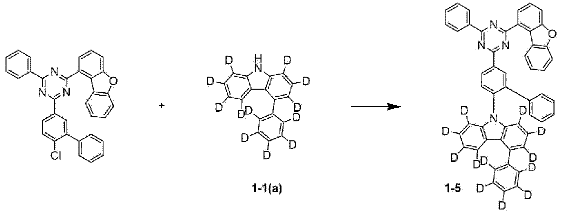

A yellow solid compound 1-5 (14.3 g, 50%, MS: [M+H]⁺ = 729.9) was prepared in the same manner as in Preparation Example 1, except that 2-(6-chloro-[1,1'-biphenyl]-3-yl)-4-(dibenzo[b,d]furan-1-yl)-6-phenyl-1,3,5-triazine was used instead of 2-(6-chloro-[1,1'-biphenyl]-3-yl)-4,6-diphenyl-1,3,5-triazine.

### Preparation Example 6: Preparation of Compound 1-6

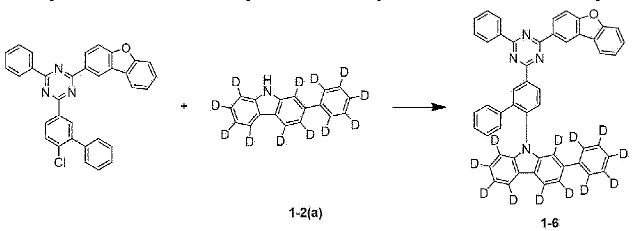

A yellow solid compound 1-6 (14.3 g, 50%, MS: [M+H]⁺ = 729.9) was prepared in the same manner as in Preparation Example 2, except that 2-(6-chloro-[1,1'-biphenyl]-3-yl)-4-(dibenzo[b,d]furan-2-yl)-6-phenyl-1,3,5-triazine was used instead of 2-(6-chloro-[1,1'-biphenyl]-3-yl)-4,6-diphenyl-1,3,5-triazine.

### Preparation Example 7: Preparation of Compound 1-7

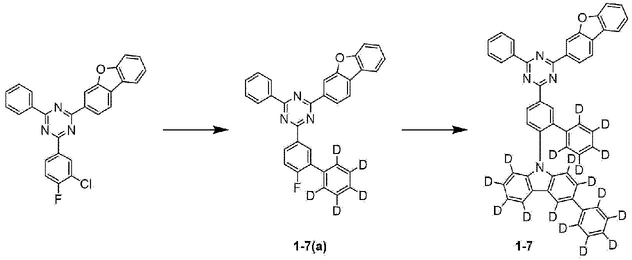

### (Preparation Example 7-1) Preparation of Compound 1-7(a)

A white solid compound 1-7(a) (13.2 g, 60%, MS: [M+H]⁺ = 499.6) was prepared in the same manner as in Preparation Example 3-2, except that 2-(3-chloro-4-fluorophenyl)-4-(dibenzo[b,d]furan-3-yl)-6-phenyl-1,3,5-triazine was used instead of 2-(3-chloro-4-fluorophenyl)-4,6-diphenyl-1,3,5-triazine.

### (Preparation Example 7-2) Preparation of Compound 1-7

A yellow solid compound 1-7 (24 g, 76%, MS: [M+H]⁺ = 644.9) was prepared in the same manner as in Preparation Example 3-3, except that Compound 1-7(a) was used instead of Compound 1-3(b).

### Preparation Example 8: Preparation of Compound 1-8

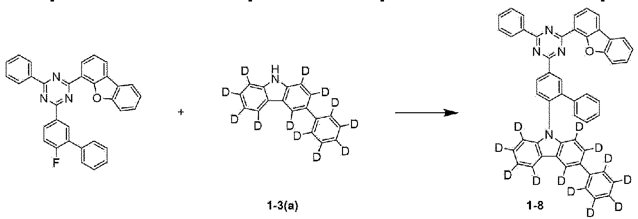

A yellow solid compound 1-8 (20.4 g, 69%, MS: [M+H]⁺ = 729.9) was prepared in the same manner as in Preparation Example 1-2, except that 2-(dibenzo[b,d]furan-4-yl)-4-(6-fluoro-[1,1'-biphenyl]-3-yl)-6-phenyl-1,3,5-triazine was used instead of 2-(6-chloro-[1,1'-biphenyl]-3-yl)-4,6-diphenyl-1,3,5-triazine, and Compound 1-3(a) was used instead of Compound 1-1(a).

### Preparation Example 9: Preparation of Compound 1-9

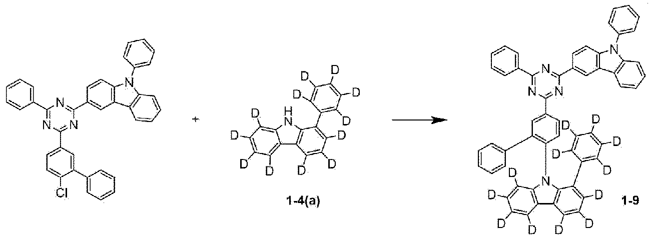

A yellow solid compound 1-9 (20.3 g, 74%, MS: [M+H]⁺ = 805) was prepared in the same manner as in Preparation Example 4-2, except that 3-(4-(6-chloro-[1,1'-biphenyl]-3-yl)-6-phenyl-1,3,5-triazin-2-yl)-9-phenyl-9H-carbazole was used instead of 2-([1,1'-biphenyl]-4-yl)-4-(6-chloro-[1,1'-biphenyl]-3-yl)-6-phenyl-1,3,5-triazine.

### Preparation Example 10. Preparation of Compound 1-10

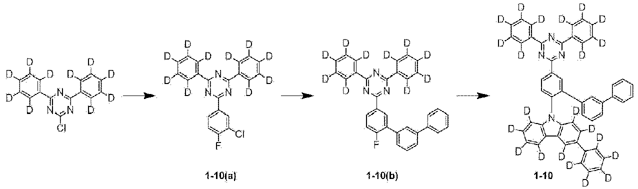

### (Preparation Example 10-1) Preparation of Compound 1-10(a)

2-Chloro-4,6-bis(phenyl-d5)-1,3,5-triazine(30 g, 108 mmol) and (3-chloro-4-fluorophenyl)boronic acid(18.8 g, 108 mmol) were added to 600 ml of tetrahydrofuran under a nitrogen atmosphere, and the mixture was stirred and refluxed. Then, potassium carbonate (44.8 g, 324 mmol) was dissolved in 45 ml of water and added thereto, and the mixture was sufficiently stirred, and then tetrakistriphenyl-phosphinopalladium (3.7 g, 3.2 mmol) was added. After the reaction for 1 hour, the reaction mixture was cooled to room temperature, and then the resulting solid was filtered. The solid was added to 2008 mL of chloroform, dissolved, washed twice with water, and the organic layer was separated, to which anhydrous magnesium sulfate was added, stirred, then filtered, and the filtrate was distilled under reduced pressure. The concentrated compound was recrystallized from chloroform and ethyl acetate to give a while solid compound 1-10(a) (22.5g, 56%, MS: [M+H]+ = 372.9).

### (Preparation Example 10-2) Preparation of Compound 1-10(b)

A white solid compound 1-10(b) (13.2 g, 60%, MS: [M+H]⁺ = 499.6) was prepared in the same manner as in Preparation Example 3-2, except that Compound 1-10(a) was used instead of 2-(3-chloro-4-fluorophenyl)-4,6-diphenyl-1,3,5-triazine, and [1,1'-biphenyl]-3-ylboronic acid was used instead of (phenyl-d5)boronic acid.

### (Preparation Example 10-3) Preparation of Compound 1-10

A yellow solid compound 1-10 (24.9 g, 56%, MS: [M+H]⁺ = 726) was prepared in the same manner as in Preparation Example 1-2, except that Compound 1-10(b) was used instead of 2-(6-chloro-[1,1'-biphenyl]-3-yl)-4,6-diphenyl-1,3,5-triazine, and Compound 1-3(a) was used instead of Compound 1-1(a).

### Preparation Example 11. Preparation of Compound 2-1

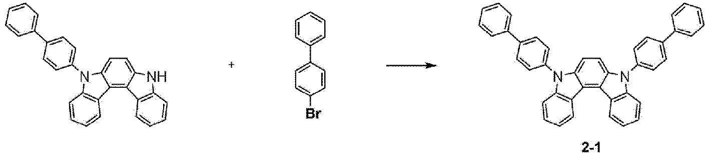

5-([1,1'-Biphenyl]-4-yl)-5,8-dihydroindolo[2,3-c]carbazole(10 g, 24.5 mmol) and 4-bromo-1,1'-biphenyl(5.7 g, 24.5mmol) were added to 200ml of xylene under a nitrogen atmosphere, and the mixture was stirred and refluxed. Then, sodium tert-butoxide (7.1 g, 73.4mmol) was added thereto, and the mixture was sufficiently stirred, and then bis(tri-tert-butylphosphine)palladium (0.4 g, 0.7 mmol) was added. After the reaction for 3 hours, the reaction mixture was cooled to room temperature, and then the resulting solid was filtered. The solid was added to 412 mL of chloroform, dissolved, washed twice with water, and the organic layer was separated, to which anhydrous magnesium sulfate was added, stirred, then filtered, and the filtrate was distilled under reduced pressure. The concentrated compound was recrystallized from chloroform and ethyl acetate to give a yellow solid Compound 2-1 (8.6g, 63%, MS: [M+H]⁺ = 561.7).

### Preparation Example 12: Preparation of Compound 2-2

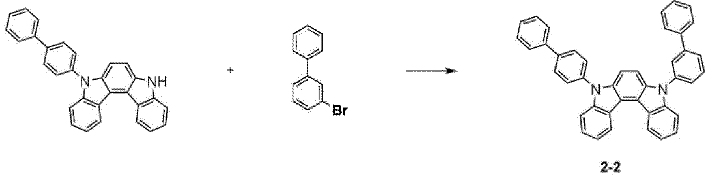

A white solid compound 2-2 (6.6 g, 48%, MS: [M+H]⁺ = 561.7) was prepared in the same manner as in Preparation Example 13, except that 3-bromo-1,1'-biphenyl was used instead of 4-bromo-1,1'-biphenyl.

### Preparation Example 13: Preparation of Compound 2-3

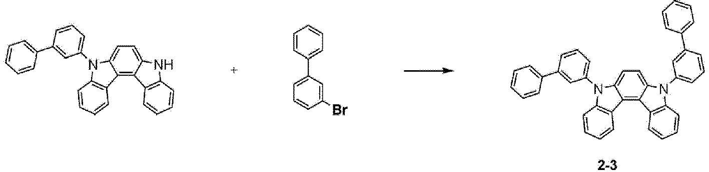

A white solid compound 2-3 (7.5 g, 55%, MS: [M+H]⁺ = 561.7) was prepared in the same manner as in Preparation Example 13, except that 5-([1,1'-biphenyl]-3-yl)-5,8-dihydroindolo[2,3-c]carbazole was used instead of 5-([1,1'-biphenyl]-4-yl)-5,8-dihydroindolo[2,3-c]carbazole, and 3-bromo-1,1'-biphenyl was used instead of 4-bromo-1,1'-biphenyl.

### Preparation Example 14: Preparation of Compound 2-4

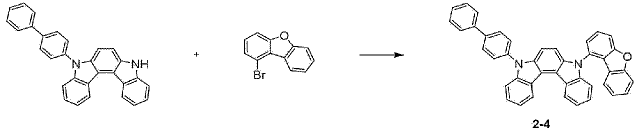

A white solid Compound 2-4 (8.6 g, 61%, MS: [M+H]⁺ = 575.7) was prepared in the same manner as in Preparation Example 13, except that 1-bromodibenzo[b,d]furan was used instead of 4-bromo-1,1'-biphenyl.

### Preparation Example 15: Preparation of Compound 2-5

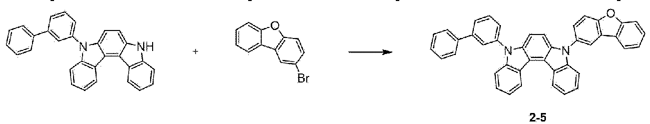

A white solid compound 2-5 (5.8 g, 41%, MS: [M+H]⁺= 575.7) was prepared in the same manner as in Preparation Example 13, except that 5-([1,1'-biphenyl]-3-yl)-5,8-dihydroindolo[2,3-c]carbazole was used instead of 5-([1,1'-biphenyl]-4-yl)-5,8-dihydroindolo[2,3-c]carbazole, and 2-bromodibenzo[b,d]furan was used instead of 4-bromo-1,1'-biphenyl.

### Preparation Example 16: Preparation of Compound 2-6

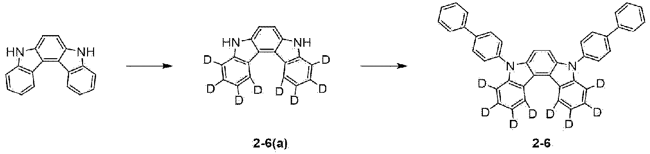

### (Preparation Example 16-1) Preparation of Compound 2-6(a)

5,8-Dihydroindolo[2,3-c]carbazole (50g, 195.1 mmol) and TfOH (10 ml) were added to C₆D₆ (500ml) under a nitrogen atmosphere, and the mixture was stirred at 40°C for 4 hours. After the reaction was completed, the temperature was lowered to room temperature, D₂O (100 ml) was added, stirred for 30 minutes, and then trimethylamine (12 ml) was added dropwise. The reaction solution was transferred to a separatory funnel and extracted with water and chloroform. The extract was dried with MgSO₄ and recrystallized from ethanol to give 30.9g of Compound 2-6(a) (Yield: 60%, MS: [M+H]+= 265)

### (Preparation Example 16-2) Preparation of Compound 2-6

Compound 2-6(a) (10 g, 37.8 mmol) and 4-bromo-1,1'-biphenyl (17.6 g, 75.6 mmol) were added to 200ml of xylene under a nitrogen atmosphere, and the mixture was stirred and refluxed. Then, sodium tert-butoxide (21.8 g, 227.0mmol) was added thereto, and the mixture was sufficiently stirred, and then bis(tri-tert-butylphosphine)palladium (2 g, 3.8mmol) was added. After the reaction for 3 hours, the reaction mixture was cooled to room temperature, and then the resulting solid was filtered. The solid was added to 645 mL of chloroform, dissolved, washed twice with water, and the organic layer was separated, to which anhydrous magnesium sulfate was added, stirred, then filtered, and the filtrate was distilled under reduced pressure. The concentrated compound was recrystallized from chloroform and ethyl acetate to give a white solid compound 2-6(17.2g, 80%, MS: [M+H]⁺= 569.8).

### Preparation Example 17: Preparation of Compound 2-7

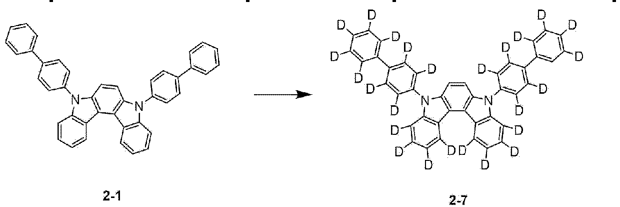

Compound 2-1(10g, 17.8 mmol) and TfOH (2 ml) were added to C₆D₆(100ml) under a nitrogen atmosphere, and the mixture was stirred at 40°C for 4 hours. After the reaction was completed, the temperature was lowered to room temperature, D₂O(20 ml) was added, stirred for 30 minutes, and then trimethylamine(12 ml) was added dropwise. The reaction solution was transferred to a separatory funnel and extracted with water and chloroform, to which anhydrous magnesium sulfate was added, stirred, then filtered, and the filtrate was distilled under reduced pressure. The concentrated compound was recrystallized from chloroform and ethyl acetate to give a white solid compound 2-7(7.9g, 76%, MS: [M+H]⁺ = 587).

### Preparation Example 18: Preparation of Compound 2-8

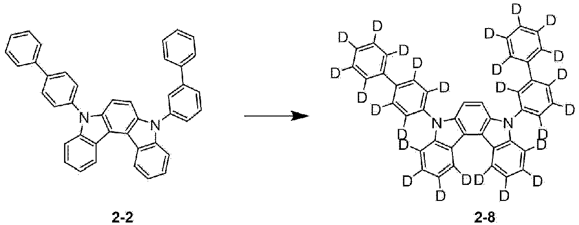

A white solid compound 2-8 (7.4 g, 71%, MS: [M+H]⁺ = 587) was prepared in the same manner as in Preparation Example 17, except that Compound 2-2 was used instead of Compound 2-1.

### [EXAMPLE]

### Example 1

A glass substrate on which a thin film of ITO (indium tin oxide) was coated in a thickness of 10 nm was put into distilled water containing the detergent dissolved therein and washed by ultrasonic wave. At this time, the used detergent was a product commercially available from Fisher Co. and the distilled water was one which had been twice filtered by using a filter commercially available from Millipore Co. The ITO was cleaned for 30 minutes, and ultrasonic cleaning was then repeated twice for 10 minutes by using distilled water. After the cleaning with distilled water was completed, the substrate was ultrasonically washed with the solvents of isopropyl alcohol, acetone, and methanol, and dried, after which it was transported to a plasma cleaner. Then, the substrate was cleaned with oxygen plasma for 5 minutes, and then transferred to a vacuum evaporator.

On the ITO transparent electrode thus prepared, the following Compound HI-A was thermally vacuum-deposited to a thickness of 60 nm to form a hole injection layer. The following Compound HAT was vacuum-deposited on the hole injection layer to form a first hole transport layer with a thickness of 5 nm, and the following Compound HA-T was vacuum-deposited on the first hole transport layer to form a second hole transport layer with a thickness of 50 nm. The following Compound HT-B was thermally vacuum-deposited to a thickness of 45 nm on the hole transport layer to form an electron blocking layer. The previously prepared Compound 1-1 and the following Compound 2-1 were mixed in a weight ratio of 1:1, and then the resulting mixture and the following Compound GD (mixture of Compound 1-1 and Compound 2-1: Compound GD) was vacuum-deposited at a weight ratio of 95:5 on the electronic blocking layer to a thickness of 40 nm to form a light emitting layer. The following Compound ET-A was vacuum-deposited to a thickness of 5 nm on the light emitting layer to form a hole blocking layer. Then, the following Compound ET-B and Compound LiQ were vacuum-deposited at a weight ratio of 1:1 on the hole blocking layer to form an electron injection and transport layer with a thickness of 35 nm.

Lithium fluoride (LiF) was deposited to a thickness of 1 nm on the electron injection and transport layer, and then aluminum was deposited to a thickness of 100 nm to form a cathode, thereby completing the manufacture of an organic light emitting device.

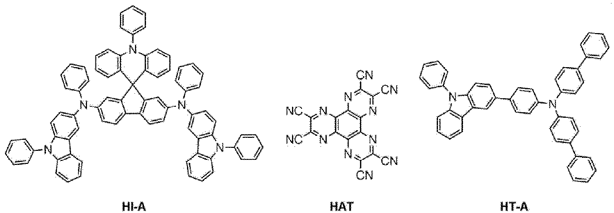

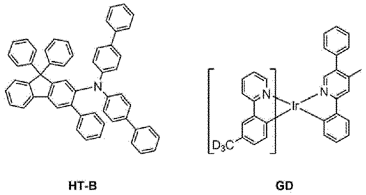

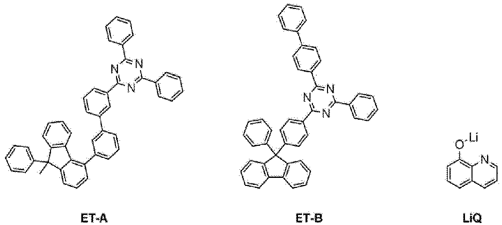

In the above-mentioned processes, the vapor deposition rate of the organic material was maintained at 0.04 nm/sec to 0.09 nm/sec, the deposition rate of lithium fluoride was maintained at 0.03 nm/sec, and the deposition rate of aluminum was maintained at 0.2 nm/sec. The degree of vacuum during the deposition was maintained at 1 * 10⁻⁷ torr to 5 * 10⁻⁵ torr.

### Examples 2 to 40, and Comparative Examples 1 to 23

The organic light emitting devices were manufactured in the same manner as in Example 1, except that in Example 1, the compounds listed in Table 1 or Table 2 below were used instead of Compound 1-1, or the compounds listed in Table 1 or Table 2 below were used instead of Compound 2-1. In Table 2 below, the structures of Compounds 3-1 to 3-5, Compounds 4-1 and 4-2 are as follows.

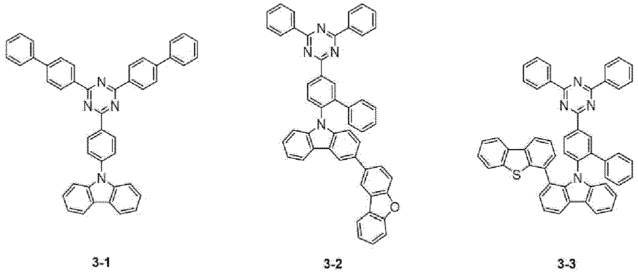

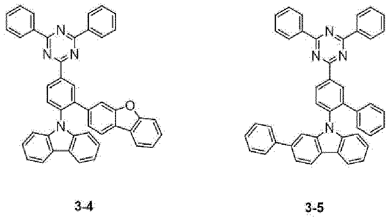

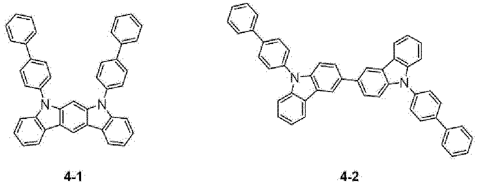

### [Experimental Example]

The voltage, efficiency, luminous color and lifetime(T95) were measured by applying a current to the organic light emitting devices manufactured in Examples 1 to 40 and Comparative Examples 1 to 23, and the results are shown in Tables 1 and 2 below. At this time, the voltage and efficiency were measured by applying a current density of 10 mA/cm², and T95 means the time (hr) required for the luminance to be reduced to 95% of the initial luminance at a current density of 20 mA/cm².

**[Table 1]**

| Category | First host | Second host | Voltage (V) (@10mA/cm²) | Efficiency (cd/A) (@10mA/cm²) | Luminous color | T₉₅(hr) (@20mA/ cm²) |
|---|---|---|---|---|---|---|
| Example 1 | 1-1 | 2-1 | 3.55 | 90.4 | Green | 195 |
| Example 2 | 1-1 | 2-4 | 3.58 | 92.1 | Green | 160 |
| Example 3 | 1-1 | 2-5 | 3.60 | 61.4 | Green | 170 |
| Example 4 | 1-1 | 2-6 | 3.56 | 90.2 | Green | 230 |
| Example 5 | 1-2 | 2-1 | 3.54 | 88.6 | Green | 205 |
| Example 6 | 1-2 | 2-2 | 3.59 | 90.4 | Green | 185 |
| Example 7 | 1-2 | 2-5 | 3.64 | 90.1 | Green | 160 |
| Example 8 | 1-2 | 2-7 | 3.55 | 88.2 | Green | 260 |
| Example 9 | 1-3 | 2-2 | 3.41 | 92.8 | Green | 200 |
| Example 10 | 1-3 | 2-3 | 3.50 | 92.9 | Green | 205 |
| Example 11 | 1-3 | 2-4 | 3.55 | 91.8 | Green | 190 |
| Example 12 | 1-3 | 2-8 | 3.41 | 92.7 | Green | 275 |
| Example 13 | 1-4 | 2-1 | 3.58 | 88.4 | Green | 195 |
| Example 14 | 1-4 | 2-2 | 3.63 | 89.5 | Green | 190 |
| Example 15 | 1-4 | 2-3 | 3.69 | 90.2 | Green | 198 |
| Example 16 | 1-4 | 2-5 | 3.64 | 90.3 | Green | 180 |
| Example 17 | 1-5 | 2-2 | 3.64 | 90.4 | Green | 195 |
| Example 18 | 1-5 | 2-3 | 3.68 | 90.2 | Green | 198 |
| Example 19 | 1-5 | 2-5 | 3.62 | 90.5 | Green | 184 |
| Example 20 | 1-5 | 2-7 | 3.58 | 89.4 | Green | 240 |
| Example 21 | 1-6 | 2-1 | 3.55 | 89.9 | Green | 195 |
| Example 22 | 1-6 | 2-3 | 3.61 | 90.5 | Green | 190 |
| Example 23 | 1-6 | 2-5 | 3.58 | 90.8 | Green | 188 |
| Example 24 | 1-6 | 2-7 | 3.57 | 89.8 | Green | 255 |
| Example 25 | 1-7 | 2-1 | 3.54 | 90.1 | Green | 188 |
| Example 26 | 1-7 | 2-4 | 3.66 | 90.6 | Green | 170 |
| Example 27 | 1-7 | 2-6 | 3.55 | 89.9 | Green | 238 |
| Example 28 | 1-7 | 2-8 | 3.60 | 90.9 | Green | 232 |
| Example 29 | 1-8 | 2-2 | 3.65 | 90.5 | Green | 189 |
| Example 30 | 1-8 | 2-3 | 3.70 | 90.6 | Green | 184 |
| Example 31 | 1-8 | 2-5 | 3.74 | 89.9 | Green | 177 |
| Example 32 | 1-8 | 2-7 | 3.59 | 89.1 | Green | 230 |
| Example 33 | 1-9 | 2-1 | 3.57 | 90.4 | Green | 200 |
| Example 34 | 1-9 | 2-3 | 3.64 | 88.9 | Green | 180 |
| Example 35 | 1-9 | 2-5 | 3.62 | 88.4 | Green | 185 |
| Example 36 | 1-9 | 2-8 | 3.59 | 90.7 | Green | 255 |
| Example 37 | 1-10 | 2-2 | 3.53 | 91.2 | Green | 204 |
| Example 38 | 1-10 | 2-3 | 3.58 | 90.8 | Green | 210 |
| Example 39 | 1-10 | 2-4 | 3.59 | 90.9 | Green | 190 |
| Example 40 | 1-10 | 2-7 | 3.49 | 90.4 | Green | 275 |

**[Table 2]**

| Category | First host | Second host | Voltage (V) (@10mA/ cm²) | Efficiency (cd/A) (@10mA/cm²) | Luminous color | T₉₅(hr) (@20mA/ cm²) |
|---|---|---|---|---|---|---|
| Comparative Example 1 | 1-1 | 4-1 | 3.59 | 73.3 | Green | 85 |
| Comparative Example 2 | 1-2 | 4-1 | 3.63 | 71.2 | Green | 80 |
| Comparative Example 3 | 1-5 | 4-1 | 3.57 | 72.7 | Green | 88 |
| Comparative Example 4 | 1-8 | 4-1 | 3.55 | 72.4 | Green | 87 |
| Comparative Example 5 | 1-1 | 4-2 | 4.01 | 77.4 | Green | 74 |
| Comparative Example 6 | 1-3 | 4-2 | 4.04 | 78.0 | Green | 70 |
| Comparative Example 7 | 1-5 | 4-2 | 3.97 | 76.7 | Green | 82 |
| Comparative Example 8 | 1-9 | 4-2 | 3.98 | 76.1 | Green | 76 |
| Comparative Example 9 | 3-1 | 2-1 | 3.77 | 75.0 | Green | 90 |
| Comparative Example 10 | 3-1 | 2-2 | 3.90 | 75.4 | Green | 95 |
| Comparative Example 11 | 3-1 | 2-3 | 3.76 | 75.1 | Green | 95 |
| Comparative Example 12 | 3-2 | 2-1 | 3.70 | 77.0 | Green | 80 |
| Comparative Example 13 | 3-2 | 2-2 | 3.68 | 76.9 | Green | 85 |
| Comparative Example 14 | 3-2 | 2-4 | 3.73 | 78.1 | Green | 88 |
| Comparative Example 15 | 3-3 | 2-1 | 3.76 | 77.6 | Green | 71 |
| Comparative Example 16 | 3-3 | 2-2 | 3.79 | 77.8 | Green | 76 |
| Comparative Example 17 | 3-3 | 2-5 | 3.71 | 74.3 | Green | 80 |
| Comparative Example 18 | 3-4 | 2-1 | 3.91 | 76.7 | Green | 91 |
| Comparative Example 19 | 3-4 | 2-2 | 3.88 | 79.0 | Green | 97 |
| Comparative Example 20 | 3-4 | 2-3 | 3.84 | 77.2 | Green | 94 |
| Comparative Example 21 | 3-5 | 2-1 | 3.53 | 88.7 | Green | 135 |
| Comparative Example 22 | 3-5 | 2-2 | 3.58 | 90.3 | Green | 120 |
| Comparative Example 23 | 3-5 | 2-5 | 3.62 | 90.1 | Green | 110 |

The compound of Chemical Formula 1 of the present disclosure induces a steric hindrance by introducing a substituted/unsubstituted aryl group into the Ar₃ position, so that the molecule is designed so that the triazine part and the carbazole part have a helical twisted structure. From this molecular structure, the electron donating properties of the carbazole substituent act to increase the overall stability of the molecule and separate the electron distribution, resulting in additional CT (charge transfer) properties, which lead to improvements in voltage, efficiency, and lifetime characteristics.

It was confirmed that among the comparative compounds, Compound 3-1 fails to form a helical twisted structure due to the absence of a substituent corresponding to the Ar₃ position of the present disclosure, which leads to a deterioration of properties. It was also confirmed that in the case of Compounds 3-2 to 3-4, a dibenzofuran or dibenzothiophene substituent showing strong electronic properties is introduced into the carbazole substituent or phenyl linker to offset the electron donating properties of the carbazole substituent, thereby suppressing the occurrence of charge transfer characteristics. It could be confirmed that Compound 3-5 does not have deuterium substituted in the carbazole unit, and thus, is structurally less twisted than deuterium-substituted carbazole, which leads to a decrease in the electronic donating properties of carbazole and a significant decrease in stability, so that a much greater decrease in lifetime is observed when deuterium is not substituted, as compared with a general deuterium substitution/non-substitution effect.

It was confirmed that the compound represented by Chemical Formula 2 of the present disclosure is based on an indolocarbazole-based core showing strong hole injection properties, and when used in combination with Chemical Formula 1 showing strong electron injection properties, electrons/holes are rapidly injected, thereby exhibiting excellent effects in improving device efficiency and voltage.

On the other hand, when Compound 4-1 or 4-2 is used, the overall electron/hole balance of the device is lost due to a decrease in hole injection characteristics, which leads to a decrease in characteristics.

**[Description of Symbols]**

| | | | |
|---|---|---|---|
| 1: | substrate | 2: | anode |
| 3: | light emitting layer | 4: | cathode |
| 5: | hole injection layer | 6: | first hole transport layer |
| 7: | second hole transport layer | 8: | electron blocking layer |
| 9: | hole blocking | 10: | electron injection and transport layer |

## Claims

1. An organic light emitting device comprising:
an anode; a light emitting layer; and a cathode,
wherein the light emitting layer includes a compound represented by the following Chemical Formula 1, and a compound represented by the following Chemical Formula 2. 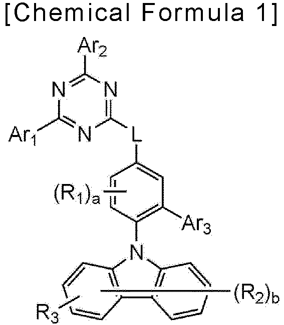
wherein, in Chemical Formula 1,
Ar₁ and Ar₂ are each independently a substituted or unsubstituted C₆₋₆₀ aryl; or a substituted or unsubstituted C₂₋₆₀ heteroaryl containing any one or more heteroatoms selected from the group consisting of N, O and S,
Ar₃ is a substituted or unsubstituted C₆₋₆₀ aryl,
L is a single bond; a substituted or unsubstituted C₆₋₆₀ arylene; or a substituted or unsubstituted C₂₋₆₀ heteroarylene containing any one or more heteroatoms selected from the group consisting of N, O, and S,
R₁ and R₂ are each independently hydrogen or deuterium,
R₃ is hydrogen, deuterium, or a substituted or unsubstituted C₆₋₆₀ aryl,
at least one of R₂ and R₃ is deuterium,
a is an integer from 0 to 3, and
b is an integer of 7, 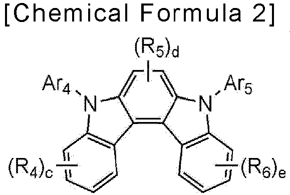
wherein, in Chemical Formula 2,
Ar₄ and Ar₅ are each independently a substituted or unsubstituted C₆₋₆₀ aryl; or a substituted or unsubstituted C₂₋₆₀ heteroaryl containing any one or more heteroatoms selected from the group consisting of N, O and S,
R₄ to R₆ are each independently hydrogen, or deuterium,
c and e are integers from 0 to 4, and
d is an integer from 0 to 2.

2. The organic light emitting device of claim 1, wherein:
Ar₁ and Ar₂ are each independently phenyl, biphenylyl, dibenzofuranyl, dibenzothiophenyl, carbazolyl, or phenyl carbazolyl,
wherein the Ar₁ and Ar₂ are each independently unsubstituted or substituted with at least one deuterium.

3. The organic light emitting device of claim 1, wherein:
Ar₁ and Ar₂ are each independently any one selected from the group consisting of:

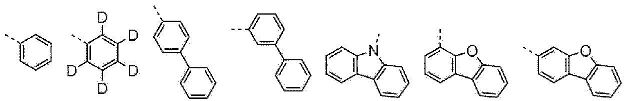

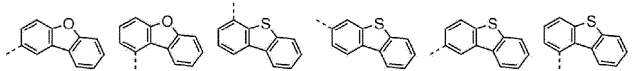

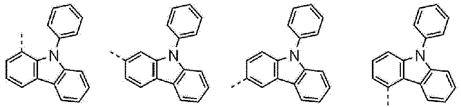

4. The organic light emitting device of claim 1, wherein:
at least one of Ar₁ and Ar₂ is phenyl, or phenyl substituted with five deuteriums.

5. The organic light emitting device of claim 1, wherein:
Ar₃ is phenyl, or biphenylyl, and
Ar₃ is unsubstituted or substituted with at least one deuterium.

6. The organic light emitting device of claim 1, wherein:
Ar₃ is any one selected from the group consisting of:

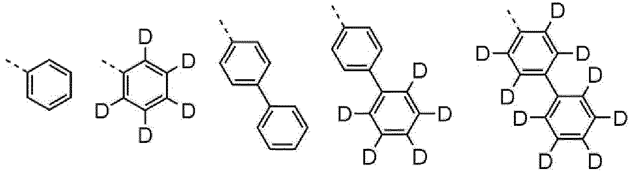

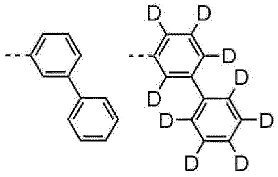

7. The organic light emitting device of claim 1, wherein:
L is a single bond.

8. The organic light emitting device of claim 1, wherein:
R₃ is hydrogen, deuterium, phenyl, or phenyl substituted with five deuteriums.

9. The organic light emitting device of claim 1, wherein:
at least one of R₂ and R₃ is deuterium, and the others are hydrogen, deuterium, phenyl, or phenyl substituted with 1 to 5 deuteriums.

10. The organic light emitting device of claim 1, wherein:
the compound represented by Chemical Formula 1 is any one selected from the group consisting of:

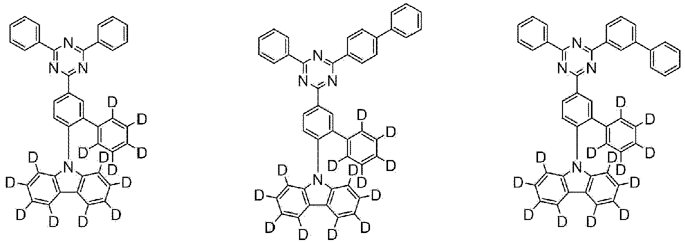

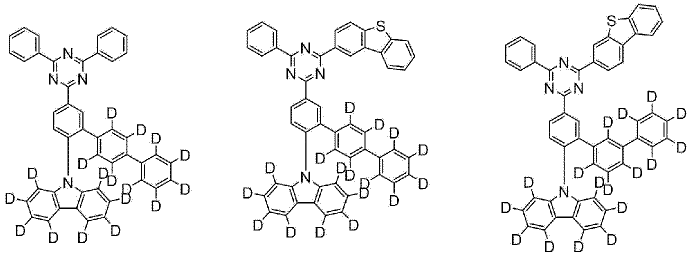

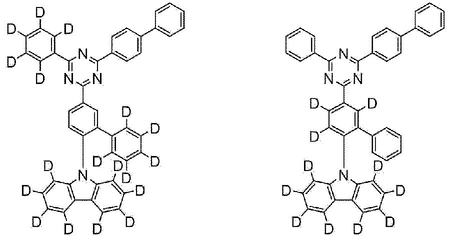

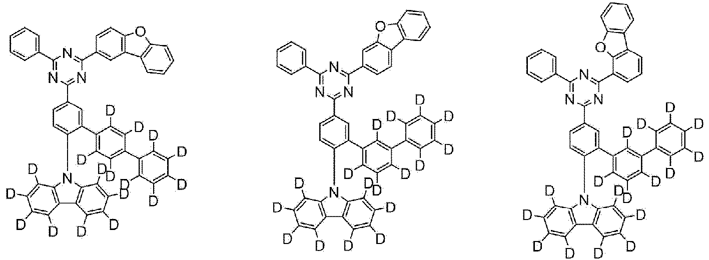

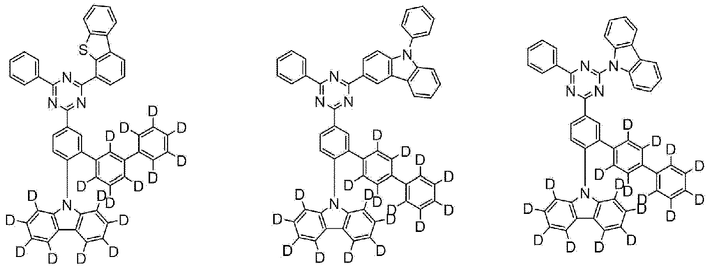

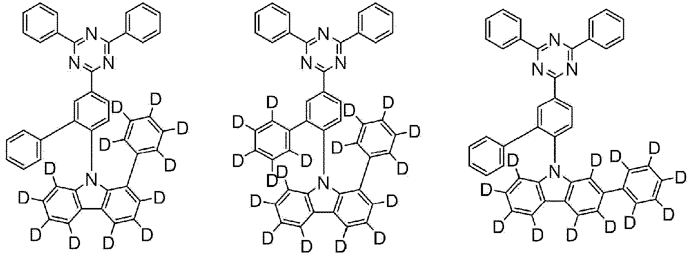

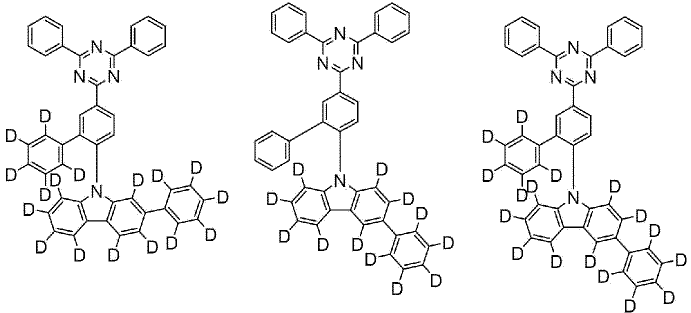

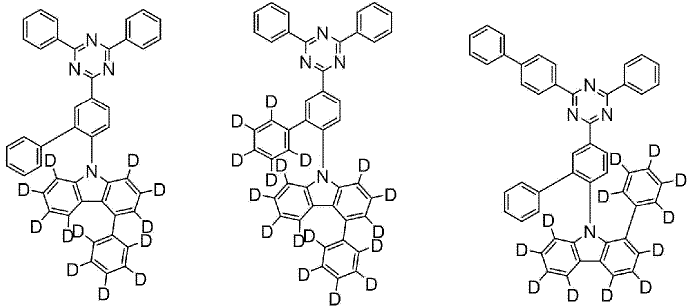

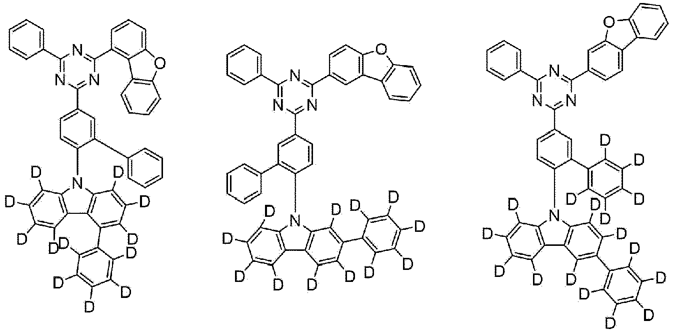

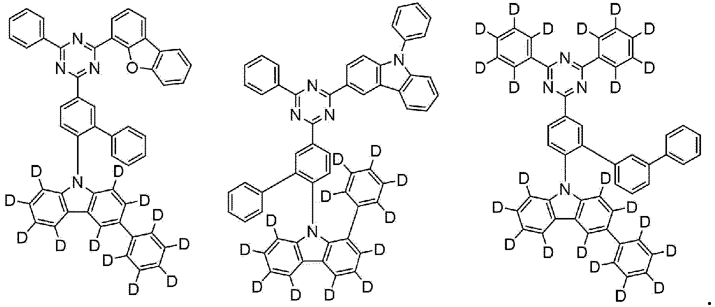

11. The organic light emitting device of claim 1, wherein:
Ar₄ and Ar₅ are each independently biphenylyl, terphenylyl, dibenzofuranyl, dibenzofuranyl phenyl, dibenzothiophenyl, or phenyl carbazolyl,
wherein the Ar₄ and Ar₅ are unsubstituted or substituted with at least one deuterium.

12. The organic light emitting device of claim 1, wherein:
Ar₄ and Ar₅ are each independently any one selected from the group consisting of:

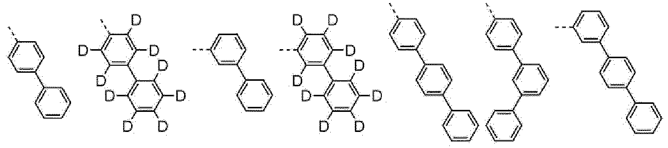

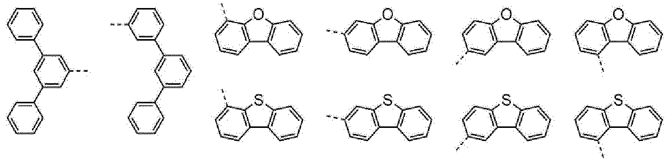

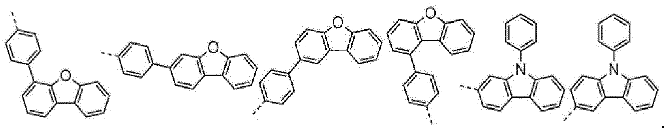

13. The organic light emitting device of claim 1, wherein:
at least one of Ar₄ and Ar₅ is a substituted or unsubstituted C₆₋₆₀ aryl.

14. The organic light emitting device of claim 1, wherein:
at least one of Ar₄ and Ar₅ is any one selected from the group consisting of:

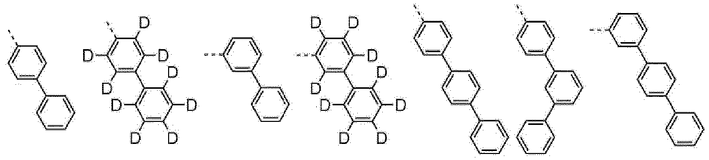

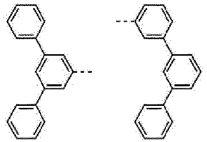

15. The organic light emitting device of claim 1, wherein:
the compound represented by Chemical Formula 2 is any one selected from the group consisting of:
